# EUROPEAN PATENT SPECIFICATION

(11) **EP 3 419 144 B1**
(45) Date of publication and mention of the grant of the patent: **30.09.2020**
(21) Application number: 18178296.2
(22) Date of filing: 18.06.2018
(51) Int. Cl.: H02J 50/05, H02J 50/00, B60L 53/00, B60L 53/51, B60L 53/53, B60L 53/54, B60L 53/55

(54) **WIRELESS POWER TRANSMISSION SYSTEM, POWER TRANSMITTING DEVICE, AND POWER RECEIVING DEVICE**
SYSTEM ZUR DRAHTLOSEN STROMÜBERTRAGUNG, STROMÜBERTRAGUNGSVORRICHTUNG UND STROMEMPFANGSVORRICHTUNG
SYSTÈME DE TRANSMISSION DE PUISSANCE SANS FIL, DISPOSITIF DE TRANSMISSION DE PUISSANCE ET DISPOSITIF DE RÉCEPTION DE PUISSANCE

(30) Priority: 21.06.2017 JP 2017121465
(43) Date of publication of application: 26.12.2018
(73) Proprietor: Panasonic Intellectual Property Management Co., Ltd., Osaka-shi, Osaka 540-6207 (JP)
(72) Inventor: KANNO, Hiroshi, Osaka-shi, Osaka 540-6207 (JP)
(74) Representative: Grünecker Patent- und Rechtsanwälte PartG mbB

(56) References cited:
- EP-A1- 2 782 214
- WO-A1-2017/056343
- GB-A- 2 526 711
- KR-A- 20160 118 907
- US-A1- 2011 266 882

## Description

### BACKGROUND

### 1. Technical Field:

The present disclosure relates to a wireless power transmission system, and a power transmitting device and a power receiving device for use in the wireless power transmission system.

### 2. Description of the Related Art:

In recent years, wireless power transmission techniques have been developed for transmitting electric power wirelessly, i.e., in a contactless manner, to devices that are capable of moving or being moved, e.g., mobile phones and electric vehicles. The wireless power transmission techniques include methods based on electromagnetic induction and methods based on electric field coupling. Among these, a wireless power transmission system based on the electric field coupling method includes a pair of power transmitting electrodes (hereinafter, referred to also as a "transmitting electrode pair") and a pair of power receiving electrodes (hereinafter, referred to also as a "receiving electrode pair") facing each other. AC power is transferred wirelessly from the pair of power transmitting electrodes to the pair of power receiving electrodes. Such a wireless power transmission system based on the electric field coupling method is used in applications where electric power is transferred to a load from a pair of power transmitting electrodes on or under a road surface or a floor surface. Japanese Laid-Open Patent Publication No. 2010-193692 discloses one example of such a wireless power transmission system based on the electric field coupling method.
Document D1 discloses a power transmission apparatus has capacitors that are connected in series between an active electrode and a passive electrode. A power receiving apparatus has capacitors that are connected in series between an active electrode and a passive electrode. When a capacitance between the active electrodes is represented by Caa, a capacitance between the passive electrodes is represented by Cpp, and reactance values of the capacitors are represented by X1, X2, X3 and X4, respectively, the active electrodes, the passive electrodes, and the capacitors are set to satisfy the following formulae: Cpp/Caa=X1/X2=X3/X4 and Cpp≥Caa. Consequently, a wireless power transmission system capable of stabilizing operations of a load circuit on the power receiving apparatus side is provided.

### SUMMARY

With a conventional wireless power transmission system based on the electric field coupling method, if a condition such as the length of the electrode pair of the power transmitting device or the power receiving device, or the ambient environment of a site where the electrode pair is installed (i.e., presence/absence of electrically conductive material), is different from the condition assumed at the time of designing the power transmitting device or the power receiving device, desired power transmission characteristics are not provided. The present disclosure provides a technique to provide, with certainty, desired power transmission characteristics even if the conditions for installing the transmitting electrode pair or the receiving electrode pair are different from those assumed at the time of designing.

The invention is defined by the subject matter of the independent claims.
The term "embodiment" is meant as an illustrative example helpful for the understanding of the invention as defined by the claims only.

### BRIEF DESCRIPTION OF THE DRAWINGS

FIG. **1** schematically shows an example of wireless power transmission system of an electric field coupling system.
FIG. **2** shows a general structure of the wireless power transmission system shown in FIG. **1****.**
FIG. **3A** shows a state where power is transmitted from a power transmitting device including a power transmitting electrode pair **120** having a relatively long length to a transportation robot **10.**
FIG. **3B** shows a state where power is transmitted from a power transmitting device including a power transmitting electrode pair **120** having a relatively short length to the transportation robot **10.**
FIG. **4** shows an example in which an iron rod **500,** which is a conductor, is present below a floor in which the power transmitting electrode pair **120** is installed.
FIG. **5A** is a cross-sectional view schematically showing an example of line of force formed between power transmitting electrodes of the power transmitting electrode pair **120** in the case where the iron rod **500** is not present.
FIG. **5B** is a cross-sectional view schematically showing an example of line of force formed between the power transmitting electrodes of the power transmitting electrode pair **120** in the case where the iron rod **500** is present.
FIG. **6** shows another example that may change the transmission characteristic system in illustrative embodiment 1 according to the present disclosure.
FIG. **8** shows, by equivalent circuits, the power transmitting electrode pair **120** including two power transmitting electrodes having the same width and the same length with each other.
FIG. **9** is a block diagram schematically showing a structure of the wireless power transmission system in the embodiment regarding the power transmission.
FIG. **10** is a circuit diagram showing, in more detail, an example of structure of the wireless power transmission system.
FIG. **11A** schematically shows an example of structure of a power transmitting circuit **110.**
FIG. **11B** schematically shows an example of structure of a power receiving circuit **210.**
FIG. **12** shows a general structure of a wireless power transmission system in illustrative embodiment 2 according to the present disclosure.
FIG. **13** schematically shows a structure of a power transmitting device **100** in illustrative embodiment 3 according to the present disclosure.
FIG. **14** is a flowchart showing an example of operation of a power transmission test.
FIG. **15** shows a modification of embodiment 3.

### DETAILED DESCRIPTION

### (Findings which are basis of the present disclosure)

Findings which are the basis of the present disclosure will be described before describing embodiments of the present disclosure.

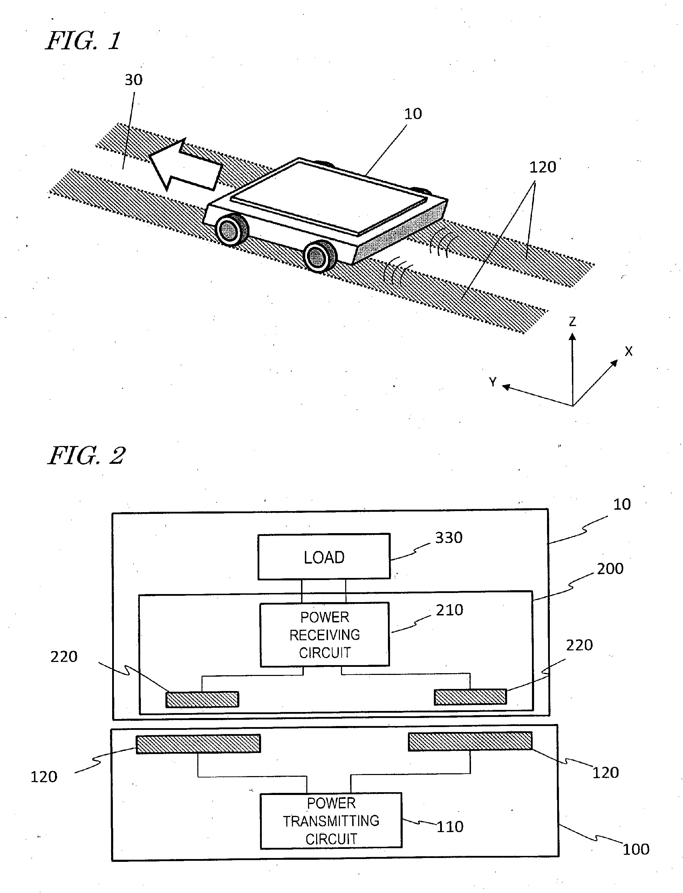

FIG. **1** is a diagram schematically showing an example of wireless power transmission system based on the electric field coupling method. The wireless power transmission system shown in FIG. **1** wirelessly transmits power to a transportation robot **10** such as an automated guided vehicle (AGV) or the like used to transport items in, for example, a factory. This system includes a pair of flat power transmitting electrodes **120** located on a floor surface **30.** The transportation robot **10** includes a pair of power receiving electrodes facing the pair of power transmitting electrode **120.** The transportation robot **10** receives, by the pair of power receiving electrodes, AC power transmitted from the pair of power transmitting electrode **120.** The received power is supplied to a load such as a motor, a secondary battery, a power storage capacitor or the like included in the transportation robot **10.** In this manner, the transportation robot **10** is driven or charged.

FIG. **1** shows XYZ coordinates representing X, Y and Z directions perpendicular to each other. In the following description, the XYZ coordinates shown in FIG. **1** will be used. A direction in which the power transmitting electrode pair **120** extends is the Y direction. A direction perpendicular to a surface of the power transmitting electrode pair **120** is the Z direction. A direction perpendicular to the Y direction and the Z direction, namely, a width direction of the power transmitting electrode pair **120** or a direction in which the power transmitting electrodes of the power transmitting electrode pair **120** are arrayed is the X direction. In the drawings of the present application, directions regarding a structural body are set for easier understanding, and do not limit, in any way, the direction in the embodiments of the present disclosure are actually carried out. The shape or size of the entirety of, or a part of, a structural body shown in the drawings does not limit the actual shape or size of the structural body in any way.

FIG. **2** shows a general structure of the wireless power transmission system shown in FIG. **1****.** The wireless power transmission system includes a power transmitting device **100** and the transportation robot **10.** The power transmitting device **100** includes the power transmitting electrode pair **120** and a power transmitting circuit **110** supplying AC power to the power transmitting electrode pair **120.** The power transmitting circuit **110** may be, for example, an AC output circuit including an inverter circuit. The power transmitting circuit **110** converts DC power supplied from a DC power source (not shown) into AC power and outputs the AC power to the power transmitting electrode pair **120.** In the case where an AC power source is provided, the power transmitting circuit **110** includes a conversion circuit converting the AC power input thereto into another AC power for power transmission.

The transportation robot **10** includes a power receiving device **200** and a load **330.** The power receiving device **200** includes a power receiving electrode pair **220,** and a power receiving circuit **210** converting AC power received by the power receiving electrode pair **220** into power required by the load **330** and supplying the power to the load **330.** The power receiving circuit **210** may include any of various circuits such as, for example, a rectifier circuit, a frequency conversion circuit and the like. The load **330** is a device that consumes or stores power such as, for example, a motor, a power storage capacitor, a secondary battery or the like. Field coupling (hereinafter, referred to also as "capacitance coupling") between the power transmitting electrode pair **120** and the power receiving electrode pair **220** allows the power to be transmitted wirelessly in the state where the power transmitting electrode pair **120** and the power receiving electrode pair **220** face each other.

Although not shown in FIG. **2****,** a matching circuit is typically provided between the power transmitting electrode pair **120** and the power transmitting circuit **110** and between the power receiving electrode pair **220** and the power receiving circuit **210.** The matching circuit is provided in order to suppress reflection of energy at the time of power transmission. The matching circuit typically includes at least one of a capacitance element and a coil.

In order to realize desired power transmission characteristics in such a wireless power transmission system, the power transmitting device **100** needs to be appropriately designed in accordance with the structure and the ambient environment (hereinafter, collectively referred to as "installation conditions") of the power receiving device **200,** whereas the power receiving device **200** needs to be appropriately designed in accordance with the installation conditions of the power transmitting device **100.** The power transmission characteristics (hereinafter, referred to also as "transmitting characteristics" or "transmission characteristics") include various factors such as, for example, transmission efficiency, power, voltage, current, heating value, and the like. The "desired transmission characteristics" may be characteristics with which the transmission efficiency is maximum in one example, and may be characteristics with which the power to be transmitted is of a predetermined value (e.g., maximum value).

In order to realize desired transmission characteristics, it is desirable that the power receiving electrode pair **220** or the matching circuit in the power receiving device **200** is appropriately designed in accordance with various installation conditions such as, for example, the length and the width of the power transmitting electrode pair **120,** the gap between the power transmitting electrodes of the power transmitting electrode pair **120,** the distance between the power transmitting electrode pair **120** and the power receiving electrode pair **220,** the positioning arrangement of a structural body (e.g., conductor) in the vicinity of the power transmitting electrode pair **120,** and the like. Similarly, it is desirable that the power transmitting electrode pair **120** or the matching circuit in the power transmitting device **100** is appropriately designed in accordance with various installation conditions such as, for example, the length and the width of the power receiving electrode pair **220,** the gap between the power receiving electrodes of the power receiving electrode pair **220,** the distance between the power transmitting electrode pair **120** and the power receiving electrode pair **220,** the positioning arrangement of a structural body (e.g., conductor) in the vicinity of the power receiving electrode pair **220,** and the like.

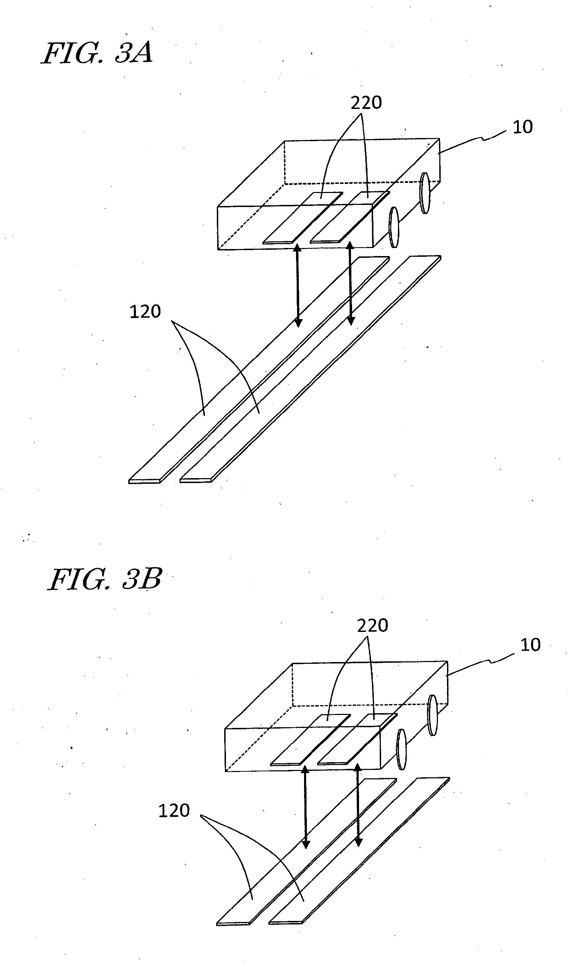

However, the installation conditions of the power transmitting device **100** or the power receiving device **200** are not always the same, and desired transmission characteristics may not be realized udder certain installation conditions. In the case where, for example, one system includes a plurality of power transmitting devices respectively including power transmitting electrode pairs **120** having different lengths, the power receiving device **200** designed optimally for a power transmitting electrode pair **120** having a specific length may not realize the desired transmission characteristics when being used with another power transmitting electrode pair **120.** Also in the case where a structural body, for example, a conductor, a semiconductor, a dielectric element or the like, not assumed at the time of designing the power receiving device **200** is present in the vicinity of the power transmitting electrode pair **120,** the desired transmission characteristics may not be realized. A similar problem occurs also in the case where one power transmitting device is required to transmit power to a plurality of power receiving devices that are installed under different installation conditions with substantially the same transmission characteristics. Hereinafter, with reference to FIG. **3A** through FIG. **5B**, examples of such a problem will be described.

FIG. **3A** and FIG. **3B** show examples of power transmission respectively using two different power transmitting devices including the power transmitting electrode pairs **120** having different lengths (referred to also as "line lengths"). FIG. **3A** shows a state where power is transmitted to the transportation robot **10** from the power transmitting device including the power transmitting electrode pair **120** having a relatively long length. FIG. **3B** shows a state where power is transmitted to the transportation robot **10** from the power transmitting device including the power transmitting electrode pair **120** having a relatively short length. The transportation robot **10** is the same in FIG. **3A** and FIG. **3B**. In the case where the transportation robot **10** is designed to realize the desired transmission characteristics when being used with the power transmitting electrode pair **120** shown in **FIG. 3A**, the desired transmission characteristics may not be realized when the transportation robot **10** is used with the power transmitting electrode pair **120** shown in FIG. **3B**. A reason for this is that when the length of the power transmitting electrodes of the power transmitting electrode pair **120** extending parallel to each other is changed, the value of the parasitic capacitance between the power transmitting electrodes of the power transmitting electrode pair **120** is also changed. As a result, the power transmission characteristics may be changed from those in the case where the transportation robot **10** is used with the power transmitting electrode pair **120** shown in FIG. **3A**. It is desirable that the line length of the power transmitting electrode pair **120** is flexibly changeable in accordance with the state of the site where the power transmitting electrode pair **120** is installed. However, when the line length is changed, the power may not be transmitted to the same power receiving device with the same characteristics because of the change in the parasitic capacitance.

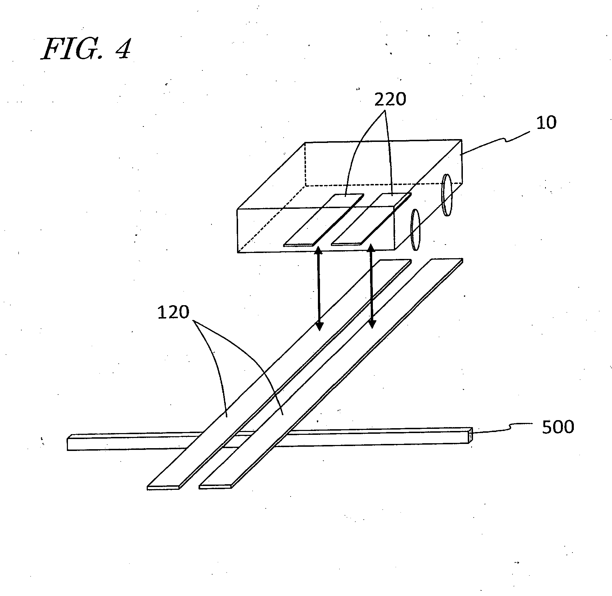

FIG. **4** shows an example in which an iron rod **500,** which is a conductor, is present below the floor in which the power transmitting electrode pair **120** is installed. In this example, the transportation robot **10** is designed to realize the desired transmission characteristics in the state where the iron rod **500** is not present. In the case where the iron rod **500** is present, unnecessary coupling occurs between the power transmitting electrode pair **120** and the iron rod **500,** and thus the parasitic capacitance between the power transmitting electrodes of the power transmitting electrode pair **120** is increased. As a result, the characteristics of power transmission from the power transmitting electrode pair **120** to the power receiving electrode pair **220** may be changed.

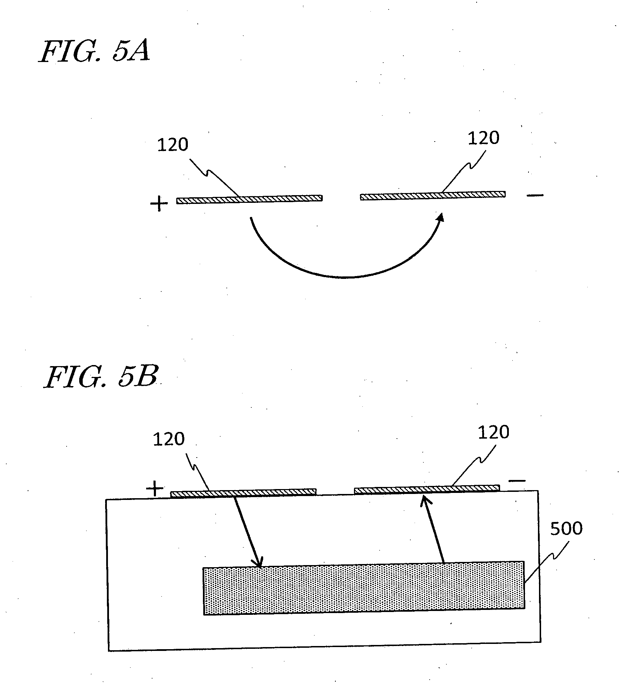

FIG. **5A** is a cross-sectional view schematically showing an example of line of force formed between the power transmitting electrodes of the power transmitting electrode pair **120** in the case where the iron rod **500** is not present. FIG. **5B** is a cross-sectional view schematically showing an example of line of force formed between the power transmitting electrodes of the power transmitting electrode pair **120** in the case where the iron rod **500** is present. In FIG. **5A** and FIG. **5B****,** the line of force is represented by the arrow(s). The power receiving device is designed to realize the desired transmission characteristics in the state where no other body is present in the vicinity of the power transmitting electrode pair **120** as shown in FIG. **5A****.** However, in actuality, the iron rod **500** is present below the power transmitting electrode pair **120** as shown in FIG. **5B****.** Therefore, unnecessary coupling is caused between the power transmitting electrode pair **120** and the iron rod **500.** This influences and changes the characteristics of power transmission between the power transmitting electrode pair **120** and the power receiving electrode pair **220.**

The iron rod **500** as described above may be present inside a wall instead of, or in addition to, below the floor. Another conductor may be present in the vicinity of the power transmitting electrode pair **120** instead of, or in addition to, the iron rod **500.** In some sites where the power transmitting device is to be installed, many such conductors may be present below the floor or inside the wall. The presence of such conductors may not be known at the time of designing the power receiving device, and may be first learned at the time of installing the power transmitting device. If, in such a case, an 'adjustment is made to realize the desired transmission characteristics in accordance with the state of the site, the convenience of the wireless power transmission system of the electric field coupling method is significantly improved. However, such an adjustable system is not conventionally known.

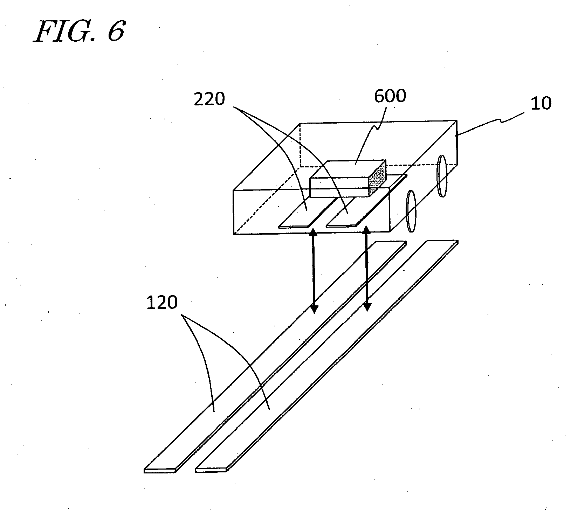

FIG. **6** shows another example that may change the transmission characteristics. In this example, a conductor used in a battery **600** mounted on the transportation robot **10** influences and causes unnecessary coupling between the power receiving electrode pair **220** and the battery **600,** and thus the parasitic capacitance between the power receiving electrodes of the power receiving electrode pair **220** is increased. Instead of, or in addition to, the conductor used in the battery **600,** a metal housing accommodating the battery **600,** for example, may influence the parasitic capacitance. In such a case, desired transmission characteristics may not be realized because, for example, the efficiency of power transmission from the power transmitting electrode pair **120** to the power receiving electrode pair **220** is decreased. In the power receiving device, a conductor may be used in, for example, a housing of, or a circuit in, the power receiving device, instead of, or in addition to, the battery **600** or the housing thereof. Instead of, or in addition to, the conductor, a semiconductor or a dielectric element located in the vicinity of the power receiving electrode pair **220** may influence the transmission characteristics. The positional arrangement of such a conductor or the like varies in accordance with the power receiving device. Therefore, a power transmitting device designed to realize the desired transmission characteristics when being used with a specific power receiving device may not realize the desired transmission characteristics when being used with another power receiving device.

In addition to the above-described examples, there may be a case where the desired transmission characteristics are not realized because the floor is formed of a material different from the assumed material. There may also be a case where, after the system starts to be used, an environmental change such as a humidity change, condensation, warp of the floor due to aging, or the like may deteriorate the transmission characteristics. The "deterioration of transmission characteristics" encompasses a fluctuation in the output power and a fluctuation in the output voltage as well as the decline in the efficiency.

As described above, the power transmission characteristics of the wireless power transmission system of the electric field coupling method is influenced by the structure of the power transmitting electrode pair **120** or the power receiving electrode pair **220,** or the environment in which the power transmitting electrode pair **120** or the power receiving electrode pair **220** is installed. At the time of designing the power transmitting device **100** or the power receiving device **200,** the conditions may not be known yet. Therefore, it is desired that an adjustment is made at the site to realize the desired transmission characteristics. In addition, if, it is possible to, after the system starts to be used, make an adjustment to make the power transmitting device **100** or the power receiving device **200** suitable to the changed environment and thus to realize the desired transmission characteristics, the convenience is further improved.

Based on the above-described consideration, the present inventor conceived the embodiments of the present disclosure described below.

A power transmitting system in an embodiment according to the present disclosure is usable in a wireless power transmission system based on an electric field coupling method, the power transmitting system including:
a first power transmitting device; and
a second power transmitting device;
wherein:
   the first power transmitting device includes:
      a first power transmitting electrode pair, and
      a first matching circuit connected with the first power transmitting electrode pair;
   the second power transmitting device includes:
      a second power transmitting electrode pair, and
      a second matching circuit connected with the second power transmitting electrode pair;
   a parasitic capacitance between the electrodes of the first power transmitting electrode pair is smaller than a parasitic capacitance between the electrodes of the second power transmitting electrode pair; and
   the first matching circuit has a shunt capacitance larger than a shunt capacitance of the second matching circuit.

According to the aspect set forth above, the parasitic capacitance between the electrodes of the first power transmitting electrode pair is smaller than the parasitic capacitance between the electrodes of the second power transmitting electrode pair. For example, the length of the first power transmitting electrode pair is shorter than the length of the second power transmitting electrode pair. Alternatively, the second power transmitting electrode pair is located in an environment where the parasitic capacitance between the electrodes of the second power transmitting electrode pair is made larger than the environment where the first power transmitting electrode pair is located. The "environment where the parasitic capacitance is made large" may be, for example, an environment where a conductor such as an iron rod or the like is located in the vicinity of the second power transmitting electrode pair.

The first matching circuit has a shunt capacitance larger than the shunt capacitance of the second matching circuit. For example, the first matching circuit includes a matching circuit having the same structure as that of the second matching circuit and a shunt capacitance element. The shunt capacitance element may be located at one of ends, of the first matching circuit, closer to the first power transmitting electrode pair.

In the above-described embodiment, the parasitic capacitance difference between the second power transmitting electrode pair and the first power transmitting electrode pair may be compensated for by the shunt capacitance additionally included in the first matching circuit. As a result, the transmission characteristic may be from being fluctuated.

Herein, it is assumed that a difference between the shunt capacitance of the first matching circuit and the shunt capacitance of the second matching circuit is ΔCc1, and a difference between the parasitic capacitance between the electrodes of the second power transmitting electrode pair and the parasitic capacitance between the electrodes of the first power transmitting electrode pair is ΔCsh1. The first matching circuit and the second matching circuit are respectively connected with inverter circuits having the same characteristics. In this case, it is considered that if ΔCc1 and ΔCsh1 match each other, the power transmission characteristics of the first power transmitting device and the power transmission characteristics of the second power transmitting device substantially match each other. Even if ΔCc1 and ΔCsh1 do not match each other, as long as the absolute value of (ΔCc1 - ΔCsh1)/ΔCsh1 is 0.5 or smaller, the fluctuation in the transmission characteristics may be made sufficiently small. More preferably, ΔCc1 is set such that the absolute value of (ΔCc1 - ΔCsh1)/ΔCsh1 is 0.2 or smaller. Still more preferably, ΔCc1 is set such that the absolute value of (ΔCc1 - ΔCsh1)/ΔCsh1 is 0.1 or smaller.

The first power transmitting device or the second power transmitting device in the power transmitting system in the above-described embodiment may be produced or marketed as an independent product. Thus, the power transmitting device in such an independent form is encompassed in the scope of the present disclosure. A wireless power transmission system including the power transmitting system and a power receiving device allowing power to be transmitted between the power receiving device and either the first power transmitting device or the second power transmitting device may be provided.

A power receiving system in another embodiment according to the present disclosure is a power receiving system usable in a wireless power transmission system based on an electric field coupling method, the power receiving system including:
a first power receiving device; and
a second power receiving device;
wherein:
   the first power receiving device includes:
      a first power receiving electrode pair, and
      a first matching circuit connected with the first power receiving electrode pair;
   the second power receiving device includes:
      a second power receiving electrode pair, and
      a second matching circuit connected with the second power receiving electrode pair;
   a parasitic capacitance between the electrodes of the first power receiving electrode pair is smaller than a parasitic capacitance between the electrodes of the second power receiving electrode pair; and
   the first matching circuit has a shunt capacitance larger than a shunt capacitance of the second matching circuit.

In the above-described embodiment, the parasitic capacitance between the electrodes of the first power receiving electrode pair is smaller than the parasitic capacitance between the electrodes of the second power receiving electrode pair. For example, the length of the first power receiving electrode pair is shorter than the length of the second power receiving electrode pair. Alternatively, the second power receiving electrode pair is located in an environment where the parasitic capacitance between the electrodes of the second power receiving electrode pair is made larger than the environment where the first power receiving electrode pair is located. The "environment where the parasitic capacitance is made large" may be, for example, an environment where a conductor used in, for example, a housing of, a circuit in, a battery in, the power receiving device is located in the vicinity of the second power receiving electrode pair.

The first matching circuit has a shunt capacitance larger than the shunt capacitance of the second matching circuit. For example, the first matching circuit includes a matching circuit having the same structure as that of the second matching circuit and a shunt capacitance element. The shunt capacitance element may be located at one of ends, of the first matching circuit, closer to the first power receiving electrode pair.

In the above-described embodiment, the parasitic capacitance difference between the second power receiving electrode pair and the first power receiving electrode pair may be compensated for by the shunt capacitance additionally included in the first matching circuit. As a result, the transmission characteristic may be suppressed from being fluctuated.

Herein, it is assumed that a difference between the shunt capacitance of the first matching circuit and the shunt capacitance of the second matching circuit is ΔCc2, and a difference between the parasitic capacitance between the electrodes of the second power receiving electrode pair and the parasitic capacitance between the electrodes of the first power receiving electrode pair is ΔCsh2. In this case, it is considered that if ΔCc2 and ΔCsh2 match each other, the power receiving characteristics of the first power receiving device and the power receiving characteristics of the second power receiving device substantially match each other. Even if ΔCc2 and ΔCsh2 do not match each other, as long as the absolute value of (ΔCc2 - ΔCsh2)/ΔCsh2 is 0.5 or smaller, the fluctuation in the receiving characteristics may be made sufficiently small. More preferably, ΔCc2 is set such that the absolute value of (ΔCc2 - ΔCsh2)/ΔCsh2 is 0.2 or smaller. Still more preferably, ΔCc2 is set such that the absolute value of (ΔCc2 - ΔCsh2)/ΔCsh2 is 0.1 or smaller.

The first power receiving device or the second power receiving device in the power receiving system in the above-described embodiment may be produced or marketed as an independent product. Thus, the power receiving device in such an independent form is encompassed in the scope of the present disclosure. A wireless power transmission system including the power receiving devices and a power transmitting device allowing power to be transmitted between the power transmitting device and either the first power receiving device or the second power receiving device may be provided.

A device in still another embodiment according to the present disclosure is a device usable in a power transmitting system or a power receiving system based on an electric field coupling method, wherein:
the power transmitting system or the power receiving system includes the device and another device;
each of the device and the another device is one of a power transmitting device and a power receiving device;
the device includes:
   a first electrode pair as a power transmitting electrode pair or a power receiving electrode pair,
   a matching circuit connected with the first electrode pair;
the another device includes:
   a second electrode pair as a power transmitting electrode pair or a power receiving electrode pair,
   a matching circuit connected with the second electrode pair;
a parasitic capacitance of the first electrode pair is smaller than a parasitic capacitance of the second electrode pair; and
the first matching circuit has a shunt capacitance larger than a shunt capacitance of the second matching circuit.

A system in still another embodiment according to the present disclosure includes:
a first device as the device; and
a second device as the another device.

The first device may further include a first power conversion circuit. The first matching circuit may be connected between the first power conversion circuit and the first electrode pair. The second device may further include a second power conversion circuit. The second matching circuit may be connected between the second power conversion circuit and the second electrode pair.

In the case where the first and second devices are power transmitting devices, the first and second power conversion circuits may each be, for example, an inverter circuit. In the case where the first and second devices are power receiving devices, the first and second power conversion circuits may each be, for example, a rectifier circuit. Each of the power conversion circuits is not limited to being an inverter circuit or a rectifier circuit, and may be, for example, a frequency conversion circuit or a voltage conversion circuit.

A power transmitting device in still another embodiment of the present disclosure is a power transmitting device usable in a wireless power transmission system based on an electric field coupling method, the power transmitting device including:
a power transmitting electrode pair;
a matching circuit connected with the power transmitting electrode pair, the matching circuit including at least one of a shunt capacitance element group, including a plurality of shunt capacitance elements selectable to be turned on or off, and a variable shunt capacitance element; and
a control circuit that controls each of the plurality of shunt capacitance elements to be turned on or off or controls a capacitance of the variable shunt capacitance element.

In the above-described embodiment, the power transmitting device includes the control circuit that controls each of the plurality of shunt capacitance elements to be turned on or off or controls the capacitance of the variable shunt capacitance element.

With such a structure, the shunt capacitance of the matching circuit may be adjusted at the site of installation of the power transmitting device. For example, the shunt capacitance of the matching circuit may be adjusted to be an optimal value in accordance with the length of the power transmitting electrode pair, the positioning state of the conductor or the like in the vicinity of the power transmitting electrode pair, the material of the floor, the humidity or the like. Therefore, the power transmission characteristics may be suppressed from fluctuating regardless of conditions such as the structure of the power transmitting electrode pair or the environment of the site of installation.

In an embodiment in which the matching circuit includes the shunt capacitance element group, the control circuit may sequentially change the combination of the shunt capacitance elements included in the shunt capacitance element group to be turned on or off, measure a parameter that varies in accordance with transmission characteristics, each time the combination is changed, and compare measurement results on the parameter to determine an optimal combination of the shunt capacitance elements to be turned on or off. The parameter that varies in accordance with the transmission characteristics may be, for example, voltage, power, heating value or the like. In an embodiment in which the matching circuit includes the variable shunt capacitance element, the control circuit may sequentially change the capacitance of the variable shunt capacitance element, measure a parameter that varies in accordance with transmission characteristics, each time the capacitance is changed, and compare measurement results on the parameter to determine an optimal value of the capacitance of the variable shunt capacitance element. With such an operation, the optimal value of the capacitance of the matching circuit may be automatically set.

A power receiving device in still another embodiment according to the present disclosure is a power receiving device usable in a wireless power transmission system based on an electric field coupling method, the power receiving device including:
a power receiving electrode pair;
a matching circuit connected with the power receiving electrode pair, the matching circuit including at least one of a shunt capacitance element group, including a plurality of shunt capacitance elements selectable to be turned on or off, and a variable shunt capacitance element; and
a control circuit that controls each of the plurality of shunt capacitance elements to be turned on or off or controls a capacitance of the variable shunt capacitance element.

In the above-described embodiment, the power receiving device includes the control circuit that controls each of the plurality of shunt capacitance elements to be turned on or off or controls the capacitance of the variable shunt capacitance element.

With such a structure, the shunt capacitance of the matching circuit may be adjusted at the site of installation of the power receiving device. For example, the shunt capacitance of the matching circuit may be adjusted be to an optimal value in accordance with the length of the power receiving electrode pair, the positioning state of the conductor or the like in the vicinity of the power receiving electrode pair, the material of the floor, the humidity or the like. Therefore, the power transmission characteristics may be suppressed from fluctuating regardless of conditions such as the structure of the power receiving electrode pair or the environment of the site of installation.

In an embodiment in which the matching circuit includes the shunt capacitance element group, the control circuit may sequentially change the combination of the shunt capacitance elements included in the shunt capacitance element group to be turned on or off, measure a parameter that varies in accordance with transmission characteristics, each time the combination is changed, and compare measurement results on the parameter to determine an optimal combination of the shunt capacitance elements to be turned on or off. The parameter that varies in accordance with the transmission characteristics may be, for example, voltage, power, heating value or the like. In an embodiment in which the matching circuit includes the variable shunt capacitance element, the control circuit may sequentially change the capacitance of the variable shunt capacitance element, measure a parameter that varies in accordance with transmission characteristics, each time the capacitance is changed, and compare measurement results on the parameter to determine an optimal value of the capacitance of the variable shunt capacitance element. With such an operation, the optimal value of the capacitance of the matching circuit may be automatically set.

A device in still another embodiment according to the present disclosure is a device usable as a power transmitting device or a power receiving device in a wireless power transmission system based on an electric field coupling method, the device including:
an electrode pair as a power transmitting electrode pair or a power receiving electrode pair;
a matching circuit connected with the electrode pair, the matching circuit including at least one of a shunt capacitance element group, including a plurality of shunt capacitance elements selectable to be turned on or off, and a variable shunt capacitance element; and
a control circuit that controls each of the plurality of shunt capacitance elements to be turned on or off or controls a capacitance of the variable shunt capacitance element.

The present disclosure encompasses a method for performing a power transmission test to determine an optimal value of the capacitance of the matching circuit in the power transmitting device and/or the power receiving device by use of the above-described power transmitting device and/or the above-described power receiving device. Such a power transmission test may be performed at the time of installing the power transmitting device or the power receiving device, so that setting of the matching circuit is automatically performed in accordance with the site of installation.

Such a power transmission test may be performed periodically or non-periodically after the system starts to be used, so that the shunt capacitance is adjusted to be suitable to the changed parameter, which varies in accordance with the transmission characteristics. As long as such an adjustment is performed when necessary, even if, for example, the humidity is changed, the floor is warped due to aging, or the thickness of a sheet member protecting the surface of the electrode is decreased, the influence thereof is suppressed.

In the present disclosure, provision of the above-described function of adjusting the shunt capacitance is not an indispensable element. For example, at the time of production or introduction of the power transmitting device or the power receiving device, an operator may use a measurement device to determine the value of the shunt capacitance of the matching circuit and determine a form in which at least one shunt capacitance element is connected with the circuit so as to provide an optimal value of the shunt capacitance. In this case, the shunt capacitance element may be connected with the circuit by, for example, a work of soldering or the like. Such a system includes a device in which the shunt capacitance of the matching circuit has a first value and a device in which the shunt capacitance of the matching circuit has a second value different from the first value. The work of adjusting the shunt capacitance may be performed only at the time of production or introduction of the power transmitting device or the power receiving device. In other words, the shunt capacitance may be fixed while the system is used.

Now, some terms used in this specification will be defined.

The "electric field coupling method" refers to, as described above, a method of wireless power transmission by which power is transmitted wirelessly from a power transmitting electrode pair to a power receiving electrode pair by capacitance coupling between the power transmitting electrode pair and the power receiving electrode pair.

The "matching circuit" refers to a circuit that that realizes impedance matching between an inverter circuit and a power transmitting electrode pair in a power transmitting device or between a power receiving electrode pair and a rectifier circuit in a power receiving device. The matching circuit typically includes at least one capacitance element (capacitor) and/or at least one coil (inductor). In the case where impedance matching is not needed, the matching circuit needs to include neither the capacitance element the coil. In this case, the matching circuit may be considered to include only two conductors between the inverter circuit and the power transmitting electrode pair.

The "parasitic capacitance" refers to an unnecessary component caused between power transmitting electrodes of the power transmitting electrode pair or between power receiving electrodes of the power receiving electrode pair at the time of power transmission in the state where the power transmitting electrode pair or the power receiving electrode pair is installed.

The "shunt capacitance" of a matching circuit refers to a capacitance component caused between two conductor lines included in the matching circuit. The "shunt capacitance element" refers to a capacitance element connected in parallel between the two conductor lines included in the matching circuit.

The "length of the power transmitting electrode pair" refers to the length of each of two power transmitting electrodes of the power transmitting electrode pair. The "length of the power receiving electrode pair" refers to the length of each of two power receiving electrodes of the power receiving electrode pair. In a typical embodiment of the present disclosure, the power transmitting electrodes and the power receiving electrodes have a shape extending in one direction. The size in such a direction is the "length".

The power receiving device may be mounted on, for example, a movable object. The "movable object" in the present disclosure is not limited to a vehicle such as a transportation robot as described above, and may refer to any movable object drivable by electric power. The movable object encompasses, for example, an electric vehicle including an electric motor and at least one wheel. Such a vehicle may be, for example, an automated guided vehicle (AGV) such as the above-described transportation robot or the like, a forklift, an electric vehicle (EV), an electric cart, an electric chair of the like. The "movable object" in the present disclosure encompasses a movable object with no wheel. For example, the "movable object" encompasses a two-legged robot, an unmanned aerial vehicle (UAV, so-called drone) such as a multicopter or the like, a manned electric aircraft, and an elevator.

In each of the power transmitting electrode pair and the power receiving electrode pair, the two electrodes may each be divided into a plurality of portions. Such a plurality of portions may extend in the same direction and may be located substantially parallel to each other. The plurality of portions are supplied with AC voltages of the same phase. Any adjacent two portions of these electrodes are supplied with AC voltages of opposite phases. In other words, electrodes supplied with a positive voltage and electrodes supplied with a negative voltage at a certain instance are arranged alternately. Such a structure provides an effect of suppressing leak of the electric field at a border between the adjacent two electrodes.

Hereinafter, embodiments of the present disclosure will be specifically described. An unnecessarily detailed description may be omitted. For example, a well known element, component or state may not be described, or substantially the same structure may not be described in repetition. This is to avoid the following description from being unnecessarily redundant and to make the description more easier to understand for a person of ordinary skill in the art. The present inventor provides the attached drawings and the following description for a person of ordinary skill in the art to fully understand the present disclosure, and does not intend to limit the scope of the subject of the claims by the drawings or the description. In the following description, elements having the same or similar functions will bear the same reference signs.

### (EMBODIMENT 1)

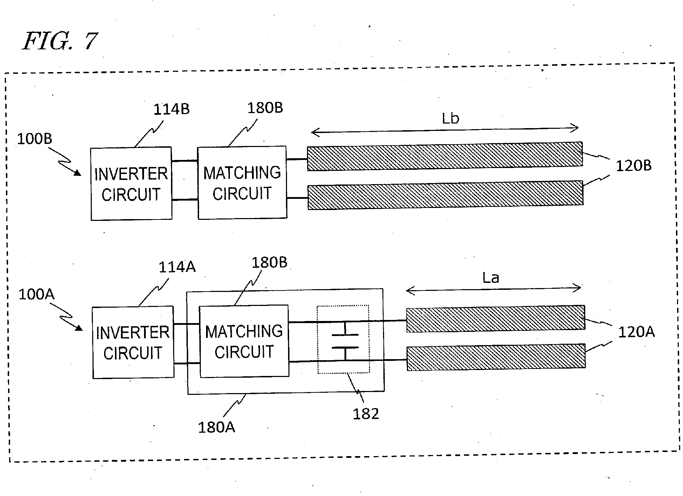

FIG. **7** schematically shows a power transmitting system in illustrative embodiment 1 according to the present disclosure. This power transmitting system is usable in a wireless power transmission system of the electric field coupling method. The power transmitting system includes a first power transmitting device **100A** and a second power transmitting device **100B.** The first power transmitting device **100A** includes a first power transmitting electrode pair **120A,** a first inverter circuit **114A,** and a first matching circuit **180A.** The second power transmitting device **100B** includes a second power transmitting electrode pair **120B,** a second inverter circuit **114B,** and a second matching circuit **180B.** The wireless power transmission system may further include a power receiving device allowing power to be transmitted between the power receiving device and both of the first power transmitting device **100A** and the second power transmitting device **100B.** Each of the power transmitting devices **100A** and **100B** and the power receiving device have substantially the same basic structure as the structure described above with reference to FIG. **1** and FIG. **2****,** which will not be described in repetition.

Length **La** of the first power transmitting electrode pair **120A** is shorter than length **Lb** of the second power transmitting electrode pair **120B.** A width of each of power transmitting electrodes of the first power transmitting electrode pair **120A** is equal to a width of each of power transmitting electrodes of the second power transmitting electrode pair **120B.** A gap of the first power transmitting electrode pair **120A** is equal to a gap of the second power transmitting electrode pair **120B.** Since the length **La** is shorter than the length **Lb,** a parasitic capacitance between the electrodes of the first power transmitting electrode pair **120A** is smaller than a parasitic capacitance between the electrodes of the second power transmitting electrode pair **120B.** Due to this parasitic capacitance difference, in the case where the first matching circuit **180A** has the same structure as that of the second matching circuit **180B,** a power receiving device designed to be suitable to the second power transmitting device **100B** does not receive power from the first power transmitting device **100A** with equivalent transmission characteristics.

In such a situation, in this embodiment, the first matching circuit **180A** is structured to have a shunt capacitance larger than a shunt capacitance of the second matching circuit **180B.** More specifically, the first matching circuit **180A** includes a matching circuit having the same structure as that of the second matching circuit **180B** and a shunt capacitance element **182.** In the example shown in FIG. **7****,** the shunt capacitance element **182** is located at one of ends, of the first matching circuit **180A,** closer to the first power transmitting electrode pair **120A,** namely, on a final stage of the first matching circuit **180A.**

A capacitance of the shunt capacitance element **182** is set to a value substantially the same as a difference between the parasitic capacitance between the electrodes of the second power transmitting electrode pair **120B** and the parasitic capacitance between the electrodes of the first power transmitting electrode pair **120A.** Namely, the amount by which the parasitic capacitance between the electrodes of the first power transmitting electrode pair **120A** is smaller than the parasitic capacitance between the electrodes of the second power transmitting electrode pair **120B** due to the length difference between the first and second power transmitting electrode pairs **120A** and **120B** is compensated for by the shunt capacitance element **182.** With such an arrangement, the power receiving device receives power from the first power transmitting device **100A** and the second power transmitting device **100B** with equivalent transmission characteristics.

The shunt capacitance element **182** may be located at any other position in the first matching circuit **180A,** instead of on the final stage of the first matching circuit **180A.** The second matching circuit **180B** included in the first matching circuit **180A** may have a larger shunt capacitance component than that of the second matching circuit **180B** included in the second power transmitting device **100B,** instead of the shunt capacitance element **182** being included in the first matching circuit **180A.**

The shunt capacitance element **182** may be a lumped element such as a chip capacitor, a film capacitor or the like. The shunt capacitance element **182** may be located on a substrate having the matching circuit **180A** mounted thereon, or in a housing accommodating the matching circuit **180B** and another circuit (e.g., frequency conversion circuit or the like). In another embodiment, such a shunt capacitance element may be formed at any position on a line that connects input/output terminals of a circuit board to antenna electrodes. The "antenna electrodes" refers to power transmitting electrodes or power receiving electrodes, more specifically, an area where the electrodes to be supplied with positive and negative voltages to obtain a coupling capacitance necessary for power transmission both have a sufficiently large width. An area outside this area, for example, an area where the electrodes are narrower is not an antenna electrode but is a power supply line. Instead of a lumped element, a capacitance component as a distributed element caused between lines of a line pair may be used as the shunt capacitance element. Alternatively, a lumped element and a distributed element may be synthesized together to provide an effect as the shunt capacitance element of the present disclosure.

The length **La** of the first power transmitting electrode pair **120A** and the length **Lb** of the second power transmitting electrode pair **120B** are each set to be sufficiently shorter than the free space wavelength λ (= c/f1) corresponding to frequency f1 of the AC power transmitted from the first power transmitting electrode pair **120A** or the second power transmitting electrode pair **120B.** "c" is the speed of light in vacuum (about 3.0 × 10⁸ cm/s). **La** and **Lb** may be set to, for example, preferably shorter than 1/10 of λ, more preferably shorter than 1/16 of λ, and still more preferably shorter than 1/20 of λ. These conditions are imposed as conditions under which the inductance of the transmission line formed of the electrode pair in the discussion described below is ignorable, but are not indispensable conditions. In the case where the frequency f1 is, for example, 500 kHz, λ is about 600 m. In this case, the line lengths **La** and **Lb** may be set to, for example, preferably shorter than 60 m, more preferably shorter than 37.5 m, and still more preferably shorter than 30 m.

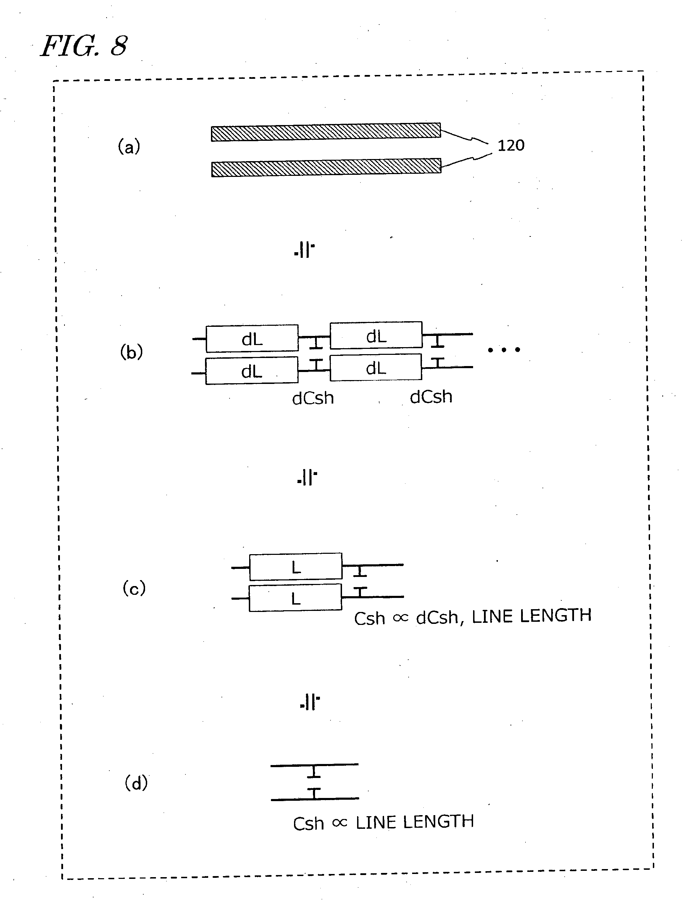

Now, with reference to FIG. **8**, the principle of this embodiment will be described.

FIG. **8** shows, by equivalent circuits, the power transmitting electrode pair **120** including two power transmitting electrodes having the same width and the same length with each other. FIG. **8(a)** shows the power transmitting electrodes of the power transmitting electrode pair **120** installed in parallel to each other. The power transmitting electrode pair **120** may be considered as a parallel-coupled transmission line. Therefore, as shown in FIG. **8(b)****,** the power transmitting electrode pair **120** may be approximated as a continuous element (distributed element) including a plurality of microscopic inductances **dL** connected in series and a plurality of microscopic capacitances **dCsh** connected in parallel. In the case where the transmission frequency is relatively low with respect to the line length as in this embodiment, as shown in FIG. **8(c)****,** the power transmitting electrode pair **120** may be approximated as a lumped element including series inductances **L** and a shunt capacitance **Csh.** The shunt capacitance **Csh** is proportional to **dCsh** and the line length.

As described above, in the case where the length of the power transmitting electrode pair **120** is sufficiently shorter than the free space wavelength λ corresponding to the transmission frequency, the inductance of the power transmitting electrode pair **120** is ignorable. In this case, as shown in FIG. **8(d)****,** the power transmitting electrode pair **120** may be approximated by the shunt capacitance **Csh** having a value in proportion to the line length. Such a capacitance **Csh** may be considered as the parasitic capacitance of the power transmitting electrode pair **120.**

In this embodiment, the power transmission between the first power transmitting device **100A** and the power receiving device, and the power transmission between the second power transmitting device **100B** and the power receiving device, are performed via air. In other words, there is no dielectric element, increasing the coupling capacitance, between each power transmitting electrode pair **120** and the power receiving electrode pair **220.** Therefore, the coupling capacitance between the power transmitting electrode pair **120** and the power receiving electrode pair **220** is relatively small, and thus the parasitic capacitance **Csh** is not ignorable.

The length of the first power transmitting electrode pair **120A** is shorter than the length of the second power transmitting electrode pair **120B** by **(Lb** - **La).** In proportion to this difference **(Lb** - **La),** a difference is caused between the parasitic capacitance between the electrodes of the second power transmitting electrode pair **120B** and the parasitic capacitance between the electrodes of the first power transmitting electrode pair **120A**. In order to compensate for this difference, the shunt capacitance element **182** is included in the first match circuit **180A**. As long as the capacitance value of the shunt capacitance element **182** is set appropriately, the capacitance of a system including the first power transmitting electrode pair **120A** and the shunt capacitance element **182,** and the capacitance of the second power transmitting electrode pair **120B**, are matched to each other.

Now, a structure of the wireless power transmission system in this embodiment regarding the power transmission will be described in more detail. In the following description, the first power transmitting device **100A** and the second power transmitting device **100B** will not be distinguished from each other and will be referred to simply as the "power transmitting device **100".** The same will be applied to the inverter circuit **114,** the matching circuit **180,** and the power transmitting electrode pair **120.** The following description on the power transmitting device **100** is applied to both of the first power transmitting device **100A** and the second power transmitting device **100B**. The structure of the system described below is merely an example, and may be modified when necessary in accordance with the required function and performance.

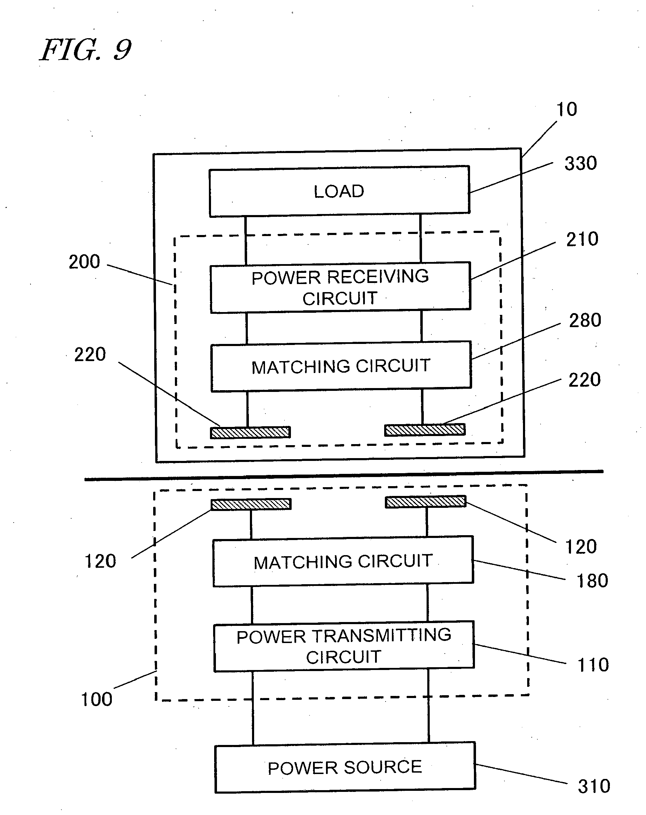

FIG. **9** is a block diagram schematically showing the structure of the wireless power transmission system in this embodiment regarding the power transmission. The power transmitting device **100** includes the power transmitting circuit **110** converting DC power supplied from an external power source **310** into AC power, the power transmitting electrode pair **120** transmitting the AC power, and the matching circuit **180** connected between the power transmitting circuit **110** and the power transmitting electrode pair **120.** The power transmitting circuit **110** includes the inverter circuit **114** shown in FIG. **7****.** The power transmitting circuit **110** is electrically connected with the power transmitting electrode pair **120** via the matching circuit **180,** and outputs the AC power to the power transmitting electrode pair **120.** In the case where the power source **310** is an AC power source, the power transmitting circuit **110** includes a conversion circuit converting the input AC power into another AC power for power transmission. The transportation robot **10** includes the power receiving device **200** and the load **330.**

The power receiving device **200** includes the power receiving electrode pair **220** forming capacitance coupling with the power transmitting electrode pair **120** to receive power, a matching circuit **280** connected with the power receiving electrode pair **220,** and the power receiving circuit **210** connected with the matching circuit **280** to convert the received AC power into a DC current and to output the DC current. The power receiving circuit **210** includes a rectifier circuit. The power receiving electrode pair **220** forms capacitance coupling with the power transmitting electrode pair **120** when facing the power transmitting electrode pair **120.** The AC power is transmitted from the power transmitting device **100** to the power receiving device **200** in a noncontact manner via the capacitance coupling. When being used to supply the AC power to the load **330,** the power receiving circuit **210** may include, instead of the rectifier circuit, a circuit converting the received AC power into another AC power required by the load **330.**

In this embodiment, there is no specific limitation of the size of each of the housing of the transportation robot **10,** the power transmitting electrode pair **120,** and the power receiving electrode pair **220.** For example, the above-described components may each be set to the following size. The length (size in the Y direction) of each of the power transmitting electrodes **120** may be set to a value in, for example, the range of 50 cm to 20 m. The width (size in the X direction) of each of the power transmitting electrodes **120** may be set to a value in, for example, the range of 0.5 cm to 2 m. The size of the housing of the transportation robot **10** in each of an advancing direction and a lateral direction may be set to a value in, for example, the range of 20 cm to 5 m. The length (size in the advancing direction) of each of the power receiving electrodes **220** may be set to a value in, for example, the range of 5 cm to 2 m. The width (size in the lateral direction) of each of the power receiving electrodes **220** may be set to a value in, for example, the range of 2 cm to 2 m. The gap of the power transmitting electrode pair **120** and the gap of the power receiving electrode pair **220** may each be set to a value in, for example, the range of 1 mm to 40 cm. The distance between the power transmitting electrodes and the power receiving electrodes may be set to, for example, about 5 mm to about 30 cm. The above-mentioned sizes are not limited to the above-mentioned numerical ranges.

The load **330** may include, for example, an electric motor for driving and a capacitor or a secondary battery for power storage. The load **330** is driven or charged by the power output from the power receiving circuit **210.**

The electric motor may be any motor such as a DC motor, a permanent magnetic synchronous motor, an induction motor, a stepping motor, a reluctance motor or the like. The motor rotates a wheel of the transportation robot **10** via, for example, a shaft and a gear to move the transportation robot **10.** The power receiving circuit **210** may include any of various circuits such as a rectifier circuit, an inverter circuit, an inverter control circuit and the like in accordance with the type of the motor. In order to drive the AC motor, the power receiving circuit **210** may include a converter circuit directly converting the frequency (transmission frequency) of the received energy (power) into a frequency for driving the motor.

The capacitor for power storage may be a high capacitance and low resistance capacitor such as, for example, an electric double-layer capacitor, a lithium ion capacitor or the like. Use of such a capacitor as a power storage device realizes more rapid charging than use of a battery (secondary battery). Instead of the capacitor, a secondary battery (e.g., lithium ion battery or the like) may be used. In this case, the time required for charging is extended, but a larger amount of energy is stored. The transportation robot 10 drives the motor by the power stored in the capacitor or the secondary battery to move.

When the transportation robot **10** is moved, the amount of stored power (amount of charged power) in the capacitor or the secondary battery is decreased. Therefore, the capacitor or the secondary battery needs to be re-charged in order to keep moving the transportation robot **10.** Thus, the transportation robot **10,** when the amount of charged power is decreased to a level lower than a predetermined threshold value during the movement thereof, moves to the vicinity of the power transmitting device **100** to charge the capacitor or the secondary battery. This movement may be performed under the control by a central management device (not shown), or may be performed by an autonomous determination of the movable object **10.** The power transmitting device **100** may be installed at a plurality of sites in a factory.

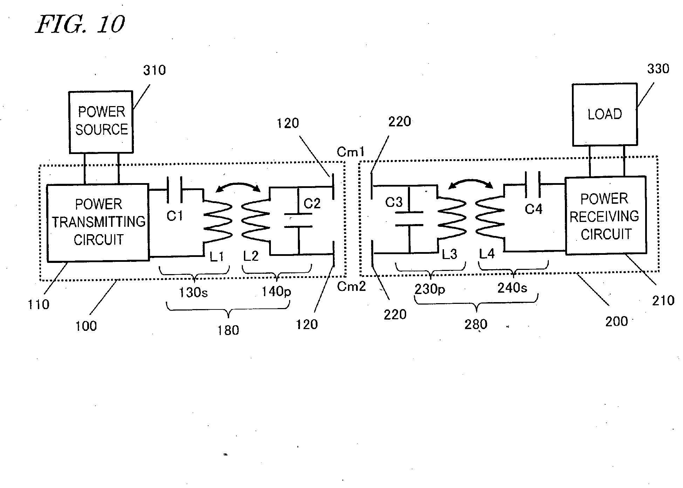

FIG. **10** is a circuit diagram showing an example of structure of the wireless power transmission system in more detail. In the example shown in FIG. **10****,** the matching circuit **180** in the power transmitting device **100** includes a series resonant circuit **130s** connected with the power transmitting circuit **110,** and a parallel resonant circuit **140p** connected with the power transmitting electrode pair **120** and forming inductance coupling with the series resonant circuit **130s.** The matching circuit **180** has a function of matching an impedance of the power transmitting circuit **110** and an impedance of the power transmitting electrode pair **120** to each other. The series resonant circuit **130s** in the power transmitting device **100** has a structure in which a first coil **L1** and a first capacitor **C1** are connected with each other in series. The parallel resonant circuit **140p** in the power transmitting device **100** has a structure in which a second coil **L2** and a second capacitor **C2** are connected with each other in parallel. The first coil **L1** and the second coil **L2** form a transformer coupled at a predetermined coupling coefficient. The first coil **L1** and the second coil **L2** are set to have a turn ratio that realizes a desired ratio of transformation (step-up ratio or step-down ratio).

The matching circuit **280** in the power receiving device **200** includes a parallel resonant circuit **230p** connected with the power receiving electrode pair **220,** and a series resonant circuit **240s** connected with the power receiving circuit **210** and forming induction coupling with the parallel resonant circuit **230p.** The matching circuit **280** has a function of matching an impedance of the power receiving electrode pair **220** and an impedance of the power receiving circuit **210** to each other. The parallel resonant circuit **230p** has a structure in which a third coil **L3** and a third capacitor **C3** are connected with each other in parallel. The series resonant circuit **240s** in the power receiving device **200** has a structure in which a fourth coil **L4** and a fourth capacitor **C4** are connected with each other in series. The third coil **L3** and the fourth coil **L4** form a transformer coupled at a predetermined coupling coefficient. The third coil **L3** and the fourth coil **L4** are set to have a turn ratio that realizes a desired ratio of transformation.

The structures of the matching circuits **180** and **280** are not limited to those shown in FIG. **10****.** For example, the series resonant circuits **130s** and the **240s** may each be replaced with a parallel resonant circuit. The parallel resonant circuits **140p** and **230p** may each be replaced with a series resonant circuit. One of, or both of, the matching circuits **180** and **280** may be omitted. In the case where the matching circuit **180** is omitted, the inverter circuit in the power transmitting circuit **110** and the power transmitting electrode pair **120** are directly connected with each other. In this case, the matching circuit **180** may be interpreted as including only two transmission lines between the inverter circuit and the power transmitting electrode pair **120.** In the case where the matching circuit **280** is omitted, the rectifier circuit in the power receiving circuit **210** and the power receiving electrode pair **220** are directly connected with each other. In this case, the matching circuit **280** may be interpreted as including only two transmission lines between the power receiving electrode pair **220** and the rectifier circuit.

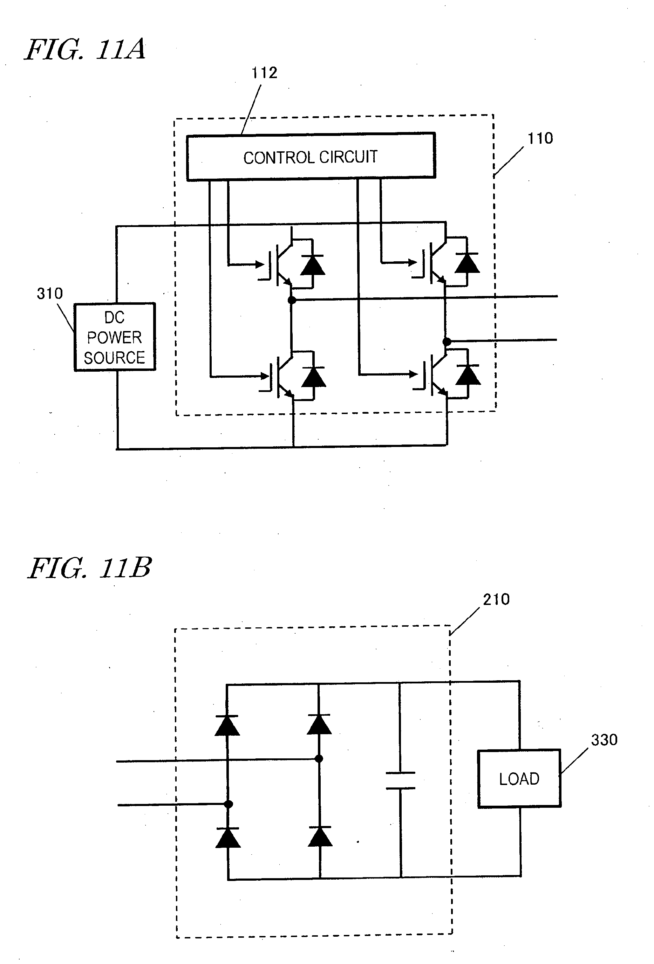

FIG. **11A** schematically shows an example of structure of the power transmitting circuit **110.** In this example, the power transmitting circuit **110** includes a full-bridge inverter circuit including four switching elements, and a control circuit **112.** Each of the switching elements may be, for example, a transistor such as an IGBT, a MOSFET or the like. The control circuit **112** includes a gate driver outputting a control signal that controls each of the switching elements to be in a on-state (conductive) or in an off-state (nonconductive), and a processor, such as a microcontroller or the like, causing the gate driver to output the control signal. Instead of the full-bridge inverter circuit shown in FIG. **11A**, another oscillation circuit such as a half-bridge inverter circuit, a class E inverter circuit or the like may be used. The power transmitting circuit **110** may include a modulation/demodulation circuit for communication or any of various sensors that measure the voltage, current or the like. In the case of including a modulation/demodulation circuit for communication, the power transmitting circuit **110** transmits data to the power receiving device **200** as overlapping the AC power. In the case where the power source **310** is an AC power source, the power transmitting circuit **110** converts the input AC power into another form of AC power having a different frequency or voltage.

The present disclosure encompasses an embodiment in which a weak AC signal (e.g., pulse signal) is transmitted to the power receiving device **200** for the purpose of data transmission, not for the purpose of power transmission. Even in such an embodiment, the weak power is considered to be transmitted. Therefore, transmission of a weak AC signal (e.g., pulse signal) is encompassed in the concept of "transmitting power" or "power transmission". Such a weak AC signal is encompassed in the concept of "AC power".

FIG. **11B** schematically shows an example of structure of the power receiving circuit **210.** In this example, the power receiving circuit **210** is a full-wave rectifier circuit including a diode bridge and a smoothing capacitor. The power receiving circuit **210** may have a structure of another rectifier. The power receiving circuit **210** may include any of various circuits such as a constant voltage/constant current control circuit, a modulation/demodulation circuit for communication and the like, in addition to the rectifier circuit. The power receiving circuit **210** converts the received AC energy into a DC energy usable by the load **330.** The power receiving circuit **210** may include any of various sensors that measure the voltage, current or the like that is output from the series resonant circuit **240s.**

Each of the coils of the resonant circuits **130s, 140p, 230p** and **240s** may be, for example, a planar coil or stacked coil formed on a circuit board, or a wound coil formed of a copper wire, a litz wire, a twisted wire or the like. As the capacitor of each of the resonant circuits **130s, 140p, 230p** and **240s,** any type of capacitor having, for example, a chip shape or a lead shape is usable. A capacitance between two lines having the air therebetween may function as each of the capacitors. Instead of such a capacitor, self-resonance characteristics of each of the coils may be used.

The power source **310** may be any power source such as, for example, a commercial power source, a primary battery, a secondary battery, a solar cell, a fuel cell, a USB (Universal Serial Bus) power source, a high-capacitance capacitor (e.g., electric double-layer capacitor), a voltage transformer connected with a commercial power source, or the like. The power source **310** is not limited to a DC power source, and may be an AC power source.

Resonant frequency f0 of each of the resonant circuits **130s, 140p, 230p** and **240s** is typically set to match the transmission frequency f1 at the time of power transmission. The resonant frequency f0 of each of the resonant circuits **130s, 140p, 230p** and **240s** does not need to precisely match the transmission frequency f1. The resonant frequency f0 of each of the resonant circuits **130s, 140p, 230p** and **240s** may be set to a value in, for example, the range of about 50 to about 150% of the transmission frequency f1. The power transmission frequency f1 may be set to, for example, 50 Hz to 300 GHz, may be set to 20 kHz to 10 GHz in an example, may be set to 20 kHz to 20 MHz in another example, and may be set to 80 kHz to 14 MHz in still another example.

In this embodiment, there is a gap between the power transmitting electrode pair **120** and the power receiving electrode pair **220,** and the distance therebetween is relatively long (e.g., about 10 mm to about 200 mm). Therefore, capacitances Cm1 and Cm2 between the electrodes are very small, and the input/output impedances of the power transmitting electrode pair **120** and the power receiving electrode pair **220** are very high (e.g., about several kiloohms). By contrast, the input/output impedances of the power transmitting circuit **110** and the power receiving circuit **210** are as low as about several ohms. In this embodiment, the parallel resonant circuits **140p** and **230p** are located closer to the power transmitting electrode pair **120** and the power receiving electrode pair **220,** and the series resonant circuits **130s** and **240s** are located closer to the power transmitting circuit **110** and the power receiving circuit **210.** Such a structure allows the impedances to be matched to each other relatively easily. A series resonant circuit has the impedance thereof become zero (0) at the time of resonance, and thus is suitable to match the impedance thereof to a low input/output impedance of an external circuit. By contrast, a parallel resonant circuit has the impedance thereof become infinitely large at the time of resonance, and thus is suitable to match the impedance thereof to a high input/output impedance of an external circuit. Therefore, as shown in FIG. **10****,** the series resonant circuit **130s** may be located at a connection point with the power source having a low input impedance, and the parallel resonant circuit **140p** may be located at a connection point with the electrode pair **120** having a high output impedance, so that the impedances are matched easily. Similarly, the parallel resonant circuit **230p** may be located on the electrode side, and the series resonant circuit **240s** may be located on the load side, so that the impedances are matched preferably in the power receiving device **200.**

In a structure in which the distance between the power transmitting electrode pair **120** and the power receiving electrode pair **220** is shortened, or in a structure in which a dielectric element is provided between the power transmitting electrode pair **120** and the power receiving electrode pair **220,** the impedances of the electrodes are decreased. In such a case, it is not necessary that the resonant circuits are located asymmetrically as described above.

In this embodiment, surfaces of the power transmitting electrodes of the power transmitting electrode pair **120** do not need to be on the same plane. The surfaces of the power transmitting electrodes and the power receiving electrodes do not need to have a completely planar shape, and, for example, may be curved or may have recessed and protruding portions. Such surfaces are encompassed in a "planar surface" as long as being generally planar. The power transmitting electrodes and the power receiving electrodes may be inclined with respect to the road surface or the floor.

In this embodiment, the wireless power transmission system includes two power transmitting devices **100.** Alternatively, the wireless power transmission system may include three or more power transmitting devices **100.** The length of the first power transmitting electrode pair **120A** and the length of the second power transmitting electrode pair **120B** may be equal to each other. In the case where, for example, in the vicinity of the second power transmitting electrode pair **120B,** there is a structural body such as a conductor or the like that increases the parasitic capacitance more than the structural body located in the vicinity of the power transmitting electrode pair **120A,** a matching circuit having substantially the same structure as that in this embodiment may be adopted. In this embodiment, even in the case where the line length, or the conditions under which the conductor is located in the vicinity of the power transmitting electrode pair 120, is different between the power transmitting devices 100, the shunt capacitance element 182 additionally included in the corresponding matching circuit may be set to have an appropriate value, so that the fluctuation in the characteristics of power transmission from each of the power transmitting devices to the power receiving device is alleviated.

In this embodiment, each of the power transmitting devices **100** includes the inverter circuit **114.** Any power transmitting device or the wireless power transmission system according to the present disclosure does not need to include an inverter circuit. Such a power transmitting device or wireless power transmission system may be produced and marketed separately from the inverter circuit.

The structure of this embodiment is applicable to a power receiving system including a plurality of power receiving devices, as well as the power transmitting system. The above description made on the electrode pair and the matching circuit in the power transmitting device is applicable to an electrode pair or a matching circuit in the power receiving device. In the case where the structure substantially the same as that in this embodiment is applied to a power receiving system, the length of each of power receiving electrodes of the power receiving electrode pair may be set to, for example, shorter than 1/10 of, more preferably shorter than 1/16 of, and still more preferably shorter than 1/20 of, the free space wavelength λ.

### (EMBODIMENT 2)

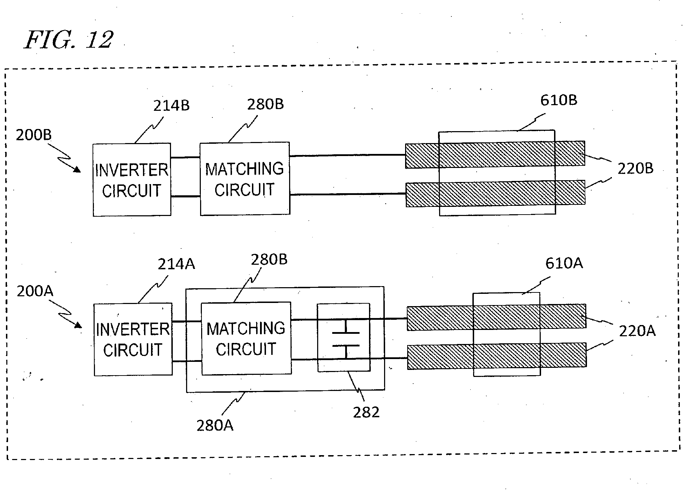

FIG. **12** shows a general structure of a wireless power transmission system in illustrative embodiment 2 according to the present disclosure. The wireless power transmission system includes a first power receiving device **200A** and a second power receiving device **200B**. The first power receiving device **200A** includes a first power receiving electrode pair **220A**, a first rectifier circuit **214A**, and a first matching circuit **280A**. The second power receiving device **200B** includes a second power receiving electrode pair **220B**, a second rectifier circuit **214B**, and a second matching circuit **280B**. The wireless power transmission system may further include a power transmitting device allowing power to be transmitted between the power transmitting device and both of the first power receiving device **200A** and the second power receiving device **200B.** Each of the power receiving devices **200A** and **200B** and the power transmitting device have substantially the same basic structure as the structure described above in embodiment 1, which will not be described in repetition.

The first power receiving electrode pair **220A** and the second power receiving electrode pair **220B** have an equal width and an equal length to each other. The gap between the power receiving electrodes of the first power receiving electrode pair **220A** is equal to the gap between the power receiving electrodes of the second power receiving electrode pair **220B**. It should be noted that a relatively large conductor **610B** is located in the vicinity of the second power receiving electrode pair **220B**, whereas a relatively small conductor **610A** is located in the vicinity of the first power receiving electrode pair **220A**. The conductors **610A** and **610B** may each be, for example, a metal element included in a battery, a circuit or a housing. Since the conductor **610B** is larger than the conductor **610A**, the parasitic capacitance between the electrodes of the first power receiving electrode pair **220A** is smaller than the parasitic capacitance between the electrodes of the second power receiving electrode pair **220B**. Therefore, in the case where the first matching circuit **280A** has the same structure as that of the second matching circuit **280B,** a power transmitting device designed to be suitable to the second power receiving device **200B** does not transmit power to the first power receiving device **200A** with equivalent transmission characteristics.

Under such a situation, in this embodiment, the first matching circuit **280A** is structured to have a shunt capacitance larger than a shunt capacitance of the second matching circuit **280B.** More specifically, the first matching circuit **280A** includes a matching circuit having the same structure as that of the second matching circuit **280B** and a shunt capacitance element **282**. In the example shown in FIG. **12**, the shunt capacitance element 282 is located at one of ends, of the first matching circuit **280A**, closer to the first power receiving electrode pair **220A**, namely, on a final stage of the first matching circuit **280A**.

A capacitance of the shunt capacitance element **282** is set to a value substantially the same as a difference between the parasitic capacitance between the electrodes of the second power receiving electrode pair **220B** and the parasitic capacitance between the electrodes of the first power receiving electrode pair **220A**. Namely, the amount by which the parasitic capacitance between the electrodes of the first power receiving electrode pair **220A** is smaller than the parasitic capacitance between the electrodes of the second power receiving electrode pair **220B** due to the length difference between the first and second power receiving electrode pairs **220A** and **220B** is compensated for by the shunt capacitance element **282**. With such an arrangement, the power transmitting device transmits power to the first power receiving device **200A** and the second power receiving device **200B** with equivalent transmission characteristics.

The shunt capacitance element **282** may be located at any other position in the first matching circuit **280A**, instead of on the final stage of the first matching circuit **280A**. The second matching circuit **280B** included in the first matching circuit **280A** may have a larger shunt capacitance component than that of the second matching circuit **280B** included in the second power receiving device **200B**, instead of the shunt capacitance element **282** being included in the first matching circuit **280A**.

In this embodiment, the wireless power transmission system includes two power receiving devices **200**. Alternatively, the wireless power transmission system may include three or more power receiving devices **200**. Instead of the parasitic capacitances of the first power receiving electrode pair **220A** and the second power receiving electrode pair **220B** being different due to the influence of the conductors **610A** and **610B**, the length of the first power receiving electrode pair **220A** and the length of the second power receiving electrode pair **220B** may be different from each other. Even in this case, the parasitic capacitance difference caused by the length difference may be alleviated by the shunt capacitance element **282** additionally included in the matching circuit **280A**. In this embodiment, even in the case where the line length, or the conditions under which the conductor is located in the vicinity of the power receiving electrode pair **220**, is different between the power receiving devices **200**, the shunt capacitance element **282** additionally included in the corresponding matching circuit may be set to have an appropriate value, so that the fluctuation in the characteristics of power transmission from the power transmitting device to each of the power receiving devices is alleviated.

In this embodiment, each of the power receiving devices **200** includes the rectifier circuit **214**. Any power receiving device or the wireless power transmission system according to the present disclosure does not need to include a rectifier circuit. Such a power receiving device or wireless power transmission system may be produced and marketed separately from the rectifier circuit.

The structure of this embodiment is applicable to a power transmitting system including a plurality of power transmitting devices, as well as the power receiving system. The above description made on the electrode pair and the matching circuit in the power receiving device is applicable to an electrode pair or a matching circuit in the power transmitting device.

### (EMBODIMENT 3)

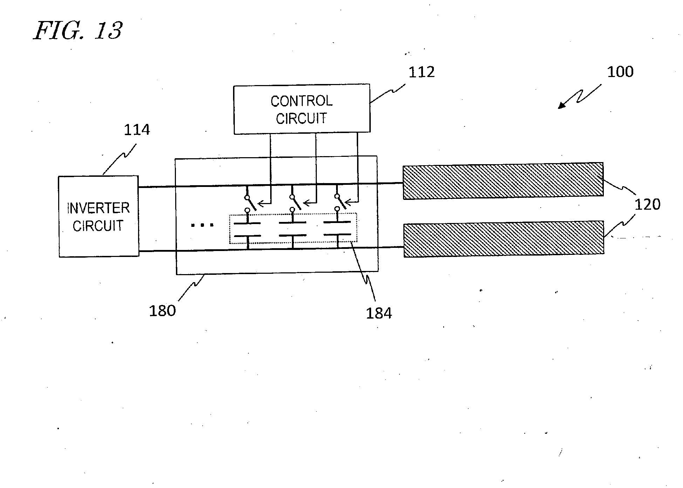

FIG. **13** schematically shows a structure of a power transmitting device **100** in illustrative embodiment 3 according to the present disclosure. The power transmitting device 100 in this embodiment includes the power transmitting electrode pair **120**, the inverter circuit **114**, the matching circuit **180** connected between the inverter circuit **114** and the power transmitting electrode pair **120**, and the control circuit **112**. The matching circuit **180** includes a shunt capacitance element group **184** including a plurality of shunt capacitance elements selectable to be turned on or off. The control circuit **112** switches each of the plurality of shunt capacitance elements to be on or off to control the entirety of the shunt capacitance component of the matching circuit **180**. Herein, the term "on" refers to that a voltage is applied, and the term "off" refers to that a voltage is not applied. Each of the capacitance elements may be turned on or off by a switch connected with the respective capacitance element.

Each of the shunt capacitance elements in the shunt capacitance element group **184** is, for example, a film capacitor or the like. The capacitance elements have different capacitances from each other. A combination of capacitance elements to be turned on or off may be changed, so that the shunt capacitance of the entirety of the matching circuit 180 is changed. In this manner, an optimal capacitance value is determined manually or automatically at the site where the power transmitting device **100** is installed. The capacitance value of the matching circuit **180** is appropriately set in accordance with, for example, the length of the power transmitting electrode pair **120**, the location of the iron rod at the site, the material of the floor, or the humidity.

The power transmitting device **100** in this embodiment automatically performs a power transmission test at the time of installation or before the start of power transmission, and thus determines an optimal combination of the capacitance elements to be turned on or off. Hereinafter, examples of the power transmission test will be described.

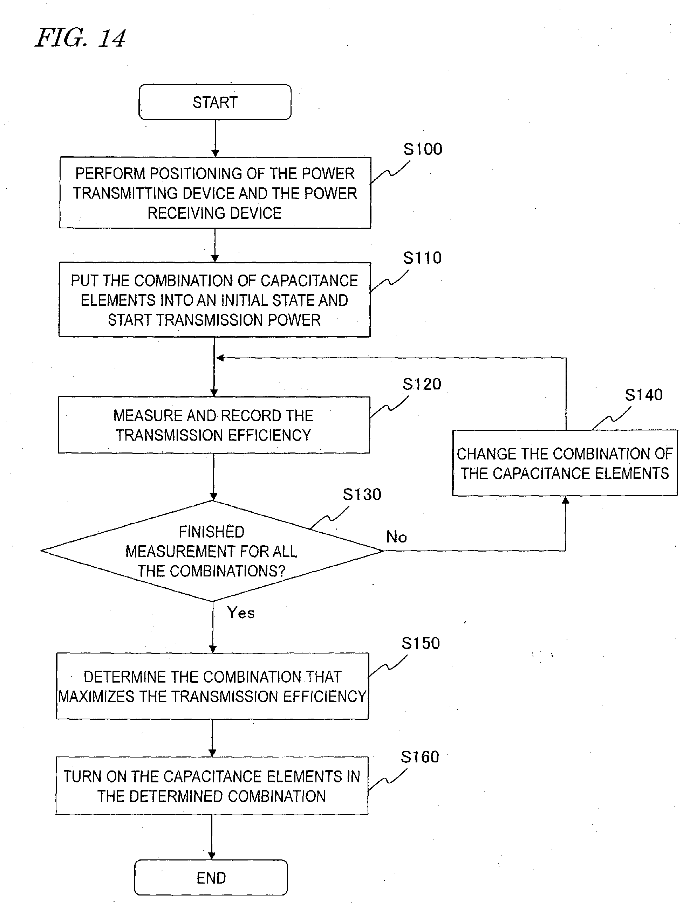

FIG. **14** is a flowchart showing an example of operation of the power transmission test. In this example, the power transmitting device automatically determines a combination of the capacitance elements that realizes characteristics maximizing the transmission efficiency as desired characteristics. First, positioning of the power transmitting device and the power receiving device is performed (step **S100**). The "positioning" refers to an operation of moving the power receiving device such that the power transmitting electrode pair **120** and the power receiving electrode pair **220** face each other. The positioning is performed based on, for example, image processing using a camera or a distance sensor, or on a fluctuation in measured values of voltage, current, power or the like in the power transmitting circuit or the power receiving circuit. Next, the control circuit **112** puts the combination of the capacitance elements in the capacitance element group **184** into an initial state and transmits power (step **S110**). The power transmitted in this step may be, for example, weak power for a test, unlike the power usually transmitted. The frequency to be used in this step may be different from the frequency used for usual power transmission. The control circuit **112** measures the transmission efficiency and records the transmission efficiency on a memory in the control circuit **112** (step **S120**). The operation in step **S120** is performed a plurality of times for different combinations of the capacitance elements in the capacitance element group **184** (step **S130, S140**). The transmission efficiency may be calculated based on, for example, the ratio between the transmitted power calculated from the measured values of voltage and current in the power transmitting device **100** and the received power calculated from the measured values of voltage and current in the power receiving device **200**. The control circuit **112** may acquire information on the received power via a communication circuit (not shown) in order to learn the power received by the power receiving device **200**.

When the measurement is finished on all the combinations of the shunt capacitance elements in the capacitance element group **184** (Yes in step **S130**), the control circuit **112** compares the measurement results on the transmission efficiency and determines the combination of the shunt capacitance elements that maximizes the transmission efficiency (step **S150**). The control circuit **112** turns on the capacitance elements included in the determined combination (step **S160**).

In this manner, the control circuit **112** sequentially changes the combinations of the capacitance elements in the capacitance element group **184** to be turned on or off, measures a parameter that varies in accordance with the transmission characteristics (in this example, transmission efficiency) for each combination, and compares the measurement results on the parameter to determine an optimal combination of the capacitance elements in the capacitance element group **184** to be turned on or off. With such an operation, the power transmission test is performed automatically. Thus, the work performed at the site is made labor-saving.

The structure shown in FIG. **13** and the operation shown in FIG. **14** are merely examples, and may be modified in various manners. For example, the number or the positional arrangement of the capacitance elements included in the capacitance element group **184** may be changed optionally. The operation shown in FIG. **14** may be performed for a plurality of frequencies to determine the combination of the capacitance elements included in the capacitance element group **184** that realizes the highest transmission efficiency. Instead of the transmission efficiency, any other parameter that varies in accordance with the transmission characteristics, for example, power, voltage, heating value or the like may be measured and the measurement results may be compared to determine an optimal capacitance value that realizes desired transmission characteristics.

Such a power transmission test may be performed within a relatively short time. For example, a test of selecting an optimal one from four combinations of the capacitance elements at three frequencies may be completed within a time of about 0.6 seconds, assuming that one cycle of measurement requires 50 ms.

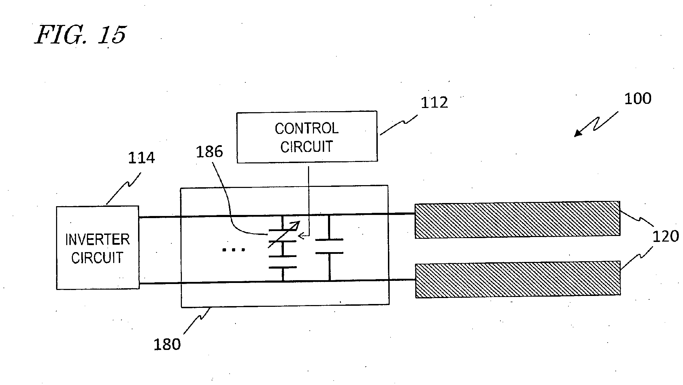

FIG. **15** shows a modification of this embodiment. In this example, the matching circuit **180** includes a variable capacitance element **186**. The control circuit **112** sequentially changes the capacitance of the variable capacitance element **186**, measures the transmission efficiency each time the capacitance is changed, and compares the measurement results on the transmission efficiency to determine an optimal capacitance value. The variable capacitance element **186** is supplied with a voltage between terminals thereof to have the electrostatic capacitance thereof changed. The control circuit **112** changes the voltage to be applied to the variable capacitance element **186** to change the capacitance value thereof. The operation in this modification is basically the same as that shown in FIG. **14**. The control circuit **112** changes the voltage to be applied to the variable capacitance element **186** to change the capacitance of the matching circuit **180**, instead of changing the combination of the capacitance elements.

The structure shown in FIG. **15** and the structure shown in FIG. **13** may be combined together. Namely, the variable capacitance element and the capacitance elements selectable to be turned on or off by a switch may be combined together.

The structures shown in FIG. **13** and FIG. **15** are applicable with no substantial change to the power receiving device **200** as well as to the power transmitting device **100**. More specifically, the matching circuit in the power receiving device **200** may include at least one of a shunt capacitance element group, including a plurality of shunt capacitance elements selectable to be turned on or off, and a variable capacitance element. The control circuit **112** in the power receiving device **200** may control each of the plurality of capacitance elements to be turned on or off, or may control the capacitance of the variable capacitance element, to set the capacitance of the entirety of the matching circuit to an optimal value. The power transmission test using the power receiving device **200** may be performed by substantially the same manner as shown in FIG. **14**.

As described above, in this embodiment, at least one of the power transmitting device and the power receiving device having the automatic adjusting function as described above is usable to perform a power transmission test to determine an optimal capacitance value of the matching circuit of at least one of the power transmitting device and the power receiving device. The power transmitting device and the power receiving device may be both used to perform a power transmission test to determine an optimal capacitance value of each of the matching circuits of the power transmitting device and the power receiving device. In such a power transmission test, the optimal capacitance value of the matching circuit of one of the power transmitting device and the power receiving device is determined, and then the optimal capacitance value of the matching circuit of the other of the power transmitting device and the power receiving device is determined. The optimal capacitance value of the matching circuit of the power transmitting device may be first determined, and then the optimal capacitance value of the matching circuit of the power receiving device may be determined. Oppositely, the optimal capacitance value of the matching circuit of the power receiving device may be first determined, and then the optimal capacitance value of the matching circuit of the power transmitting device may be determined. Such a power transmission test may be performed at a site of production, instead of the site of installation. The power transmission test may be performed periodically or non-periodically after the system starts to be used. In this manner, even if the ambient environment of the electrodes is changed along time, the transmission characteristics may be suppressed from being deteriorated.

A wireless power transmission system including a plurality of power transmitting devices and a plurality of power receiving devices may include a management device that controls the power transmitting devices and the power receiving devices. The management device may collect data indicating the relationship between the determined capacitance value and the power transmission characteristics for each pair of the power transmitting device and the power receiving device. The power transmitting devices may each transmit, to the management device, data indicating the transmission characteristics at the time of transmission to each of the power receiving devices and data indicating the combination of the capacitance elements selected for the transmission. For each pair of the power transmitting device and the power receiving device, the management device may determine how to set the capacitances of the power transmitting device and the power receiving device and issue an instruction to the power transmitting device and the power receiving device.

For transmitting power to the power receiving device, the power transmitting device in each of the examples shown in FIG. **13** through FIG. **15** performs preliminary power transmission while changing the shunt capacitance value of the matching circuit **180**, and determines the capacitance value at which the transmission efficiency is highest. The order of the shunt capacitance values to be selected in this operation may be determined by the management device. For each pair of the power transmitting device and the power receiving device, the management device collects data indicating the relationship between the capacitance value selected in the past and the transmission characteristics. The management device may statistically process the data to determine an optimal order of the capacitor combinations.

During power transmission, the management device may collect data on a fluctuation in the characteristics caused by the change in the capacitance value, from the power transmitting device or the power receiving device. The next time the power transmission is performed with the same combination of the power transmitting device and the power receiving device, the management device may execute control such that setting of the capacitance value at which the efficiency was low in the past is avoided, based on the collected data. In other words, the management device may issue an instruction such that only a part, of the capacitance states, in which the transmission efficiency is high is set in the power transmitting device and the power receiving device.

The above-described data collection may be performed during the test charging when the system is installed or introduced, before the shipment of the system, or before the system starts to be used. Data indicating an optimal capacitance state for each combination of the power transmitting device and the power receiving device may be recorded on a recording medium in the power transmitting device or the management device. Such an adjustment may be performed in advance to realize a power transmission operation more efficiently.

The wireless power transmission system in an embodiment according to the present disclosure is usable as a system transporting an item in a factory as described above. The transportation robot 10 includes a carriage onto which the item is loaded, and acts as a cart movable autonomously in the factory to transport an item to a site where the item is needed. The wireless power transmission system and the movable object according to the present disclosure are not limited to being used for such a purpose, and may be used for another purpose. For example, the movable object is not limited to an AGV, and may be any other industrial machine, a service robot, an electric vehicle, a multicopter (drone), or the like. The wireless power transmission system is not limited to being used in a factory, and may be used at any other site such as in a store, in a hospital, in a household, on a road, on a runway or the like.

As described above, the present disclosure encompasses a device, a system, a power transmitting system, a power receiving system, a wireless power transmission system, a power transmitting device, a power receiving device, and an adjusting method described in the following items.

### [Item 1]

A power transmitting system usable in a wireless power transmission system based on an electric field coupling method, the power transmitting system comprising:
a first power transmitting device; and
a second power transmitting device;
wherein:
   the first power transmitting device includes:
      a first power transmitting electrode pair, and
      a first matching circuit connected with the first power transmitting electrode pair;
   the second power transmitting device includes:
      a second power transmitting electrode pair, and
      a second matching circuit connected with the second power transmitting electrode pair;
   a parasitic capacitance between the electrodes of the first power transmitting electrode pair is smaller than a parasitic capacitance between the electrodes of the second power transmitting electrode pair; and
   the first matching circuit has a shunt capacitance larger than a shunt capacitance of the second matching circuit. [0126] The technology according to the present disclosure is usable for any device drivable by electric power, for example, a movable object such as an electric vehicle (EV), an automated guided vehicle (AGV), an unmanned aerial vehicle (UAV) or the like.

## Claims

1. A system usable as one of a power transmitting system and a power receiving system based on an electric field coupling method, the system comprising:
a first device; and
a second device;
wherein:
each of the first device and the second device is a power transmitting device in the power transmitting system, or each of the first device and the second device is a power receiving device in the power receiving system;
both of the first and second devices are capable of transmitting power to a same power receiving device, or both of the first and second devices are capable of receiving power from a same power transmitting device;
the first device includes:
a first electrode pair (120A), and
a first matching circuit (180A) connected with the first electrode pair;
the second device includes:
a second electrode pair (120B), and
a second matching circuit (180B) connected with the second electrode pair;
each of the first electrode pair and the second electrode pair is a power transmitting electrode pair, or each of the first electrode pair and the second electrode pair is a power receiving electrode pair;
a parasitic capacitance of the first electrode pair is smaller than a parasitic capacitance of the second electrode pair; and
the first matching circuit has a shunt capacitance larger than a shunt capacitance of the second matching circuit,
in order to provide desired power transmission characteristics.

2. The system of claim 1, wherein:
the first device further includes a first power conversion circuit;
the first matching circuit is connected between the first power conversion circuit and the first electrode pair;
the second device further includes a second power conversion circuit; and
the second matching circuit is connected between the second power conversion circuit and the second electrode pair.

3. The system of claim 1 or 2, wherein the first matching circuit includes a matching circuit having the same structure as that of the second matching circuit and a shunt capacitance element.

4. The system of claim 3, wherein the shunt capacitance element is located at one of ends, of the first matching circuit, closer to the first electrode pair.

5. The system of any one of claims 1 to 4, wherein a length of the first electrode pair is shorter than a length of the second electrode pair.

6. The system of any one of claims 1 to 5, wherein where a difference between the shunt capacitance of the first matching circuit and the shunt capacitance of the second matching circuit is ΔCc1 and a difference between the parasitic capacitance of the second electrode pair and the parasitic capacitance of the first electrode pair is ΔCsh1, an absolute value of (ΔCc1 - ΔCsh1)/ΔCsh1 is 0.5 or smaller.

7. A wireless power transmission system, comprising:
the system of any one of claims 1 to 6; and
another device allowing power to be transmitted between the another device and either the first device or the second device.

8. The first device usable in the system of any one of claims 1 to 6.

9. A device usable as a power transmitting device or a power receiving device for a wireless power transmission system according to claims 1 - 6 based on an electric field coupling method, the device comprising:
an electrode pair (120) as a power transmitting electrode pair or a power receiving electrode pair;
a matching circuit (180) connected with the electrode pair, the matching circuit including at least one of a shunt capacitance element group, including a plurality of shunt capacitance elements selectable to be turned on or off, and a variable shunt capacitance element; and
a control circuit (112) that controls each of the plurality of shunt capacitance elements to be turned on or off or controls a capacitance of the variable shunt capacitance element.

10. The device of claim 9, further comprising a power conversion circuit;
wherein the matching circuit (180) is connected between the power conversion circuit and the electrode pair.

11. The device of claim 9 or 10, wherein:
the matching circuit (180) includes the shunt capacitance element group; and
the control circuit (112) sequentially changes a combination of the shunt capacitance elements included in the shunt capacitance element group to be turned on or off, measures a parameter that varies in accordance with transmission characteristics, each time the combination is changed, and compares measurement results on the parameter to determine an optimal combination of the shunt capacitance elements to be turned on or off.

12. The device of claim 9, wherein:
the matching circuit (130) includes the variable shunt capacitance element; and
the control circuit (117) sequentially changes the capacitance of the variable shunt capacitance element, measures a parameter that varies in accordance with transmission characteristics, each time the capacitance is changed, and compares measurement results on the parameter to determine an optimal value of the capacitance of the variable shunt capacitance element.

13. An adjusting method using the device of any one of claims 9 to 12 to perform a power transmission test to determine an optimal value of the capacitance of the matching circuit in the device.

14. The adjusting method of claim 13, wherein the adjusting method uses a power transmitting device as the device of any one of claims 9 to 12 and a power receiving device as the device of any one of claims 9 to 12 to determine an optimal value of the capacitance of the matching circuit in one of the power transmitting device and the power receiving device, and then to determine an optimal value of the capacitance of the matching circuit in the other of the power transmitting device and the power receiving device.

## Patentansprüche

1. System, das als ein Energieübertragungssystem oder ein Energieempfangssystem auf der Basis eines elektrischen Feldkopplungsverfahrens verwendbar ist, wobei das System umfasst:
eine erste Vorrichtung und
eine zweite Vorrichtung;
wobei:
die erste Vorrichtung und die zweite Vorrichtung jeweils eine Energieübertragungsvorrichtung in dem Energieübertragungssystem ist oder die erste Vorrichtung und die zweite Vorrichtung jeweils eine Energieempfangsvorrichtung in dem Energieempfangssystem ist;
sowohl die erste als auch die zweite Vorrichtung in der Lage sind, Energie zu einer gleichen Energieempfangsvorrichtung zu übertragen, oder sowohl die erste als auch die zweite Vorrichtung in der Lage sind, Energie von einer gleichen Energieübertragungsvorrichtung zu empfangen;
die erste Vorrichtung aufweist:
ein erstes Elektrodenpaar (120A) und
eine mit dem ersten Elektrodenpaar verbundene erste Anpassungsschaltung (180A);
die zweite Vorrichtung aufweist:
ein zweites Elektrodenpaar (120B) und
eine mit dem zweiten Elektrodenpaar verbundene zweite Anpassungsschaltung (180B);
das erste Elektrodenpaar und das zweite Elektrodenpaar jeweils ein Energie übertragendes Elektrodenpaar ist oder das erste Elektrodenpaar und das zweite Elektrodenpaar jeweils ein Energie empfangendes Elektrodenpaar ist;
eine Streukapazität des ersten Elektrodenpaares kleiner ist als eine Streukapazität des zweiten Elektrodenpaares und
die erste Anpassungsschaltung eine Parallelkapazität hat, die größer ist als eine Parallelkapazität der zweiten Anpassungsschaltung, um gewünschte Energieübertragungseigenschaften bereitzustellen.

2. System nach Anspruch 1, wobei:
die erste Vorrichtung des Weiteren eine erste Energieumwandlungsschaltung aufweist;
die erste Anpassungsschaltung zwischen der ersten Energieumwandlungsschaltung und dem ersten Elektrodenpaar geschaltet ist;
die zweite Vorrichtung des Weiteren eine zweite Energieumwandlungsschaltung aufweist und
die zweite Anpassungsschaltung zwischen der zweiten Energieumwandlungsschaltung und dem zweiten Elektrodenpaar geschaltet ist.

3. System nach Anspruch 1 oder 2, wobei die erste Anpassungsschaltung eine Anpassungsschaltung mit der gleichen Struktur wie die der zweiten Anpassungsschaltung und ein Parallelkapazitätselement aufweist.

4. System nach Anspruch 3, wobei sich das Parallelkapazitätselement an einem der Enden der ersten Anpassungsschaltung befindet, das näher am ersten Elektrodenpaar liegt.

5. System nach einem der Ansprüche 1 bis 4, wobei eine Länge des ersten Elektrodenpaares kürzer ist als eine Länge des zweiten Elektrodenpaares.

6. System nach einem der Ansprüche 1 bis 5, wobei, wo eine Differenz zwischen der Parallelkapazität der ersten Anpassungsschaltung und der Parallelkapazität der zweiten Anpassungsschaltung ΔCc1 ist und eine Differenz zwischen der Streukapazität des zweiten Elektrodenpaares und der Streukapazität des ersten Elektrodenpaares ΔCsh1 ist, ein absoluter Wert von (ΔCc1 - ΔCsh1) / ΔCsh1 0,5 oder kleiner ist.

7. Drahtloses Energieübertragungssystem, das umfasst:
das System nach einem der Ansprüche 1 bis 6 und
eine weitere Vorrichtung, die es ermöglicht, die Energie zwischen der weiteren Vorrichtung und entweder der ersten Vorrichtung oder der zweiten Vorrichtung zu übertragen.

8. Erste Vorrichtung, die in dem System nach einem der Ansprüche 1 bis 6 verwendbar ist.

9. Vorrichtung, die als eine Energieübertragungsvorrichtung oder eine Energieempfangsvorrichtung für ein drahtloses Energieübertragungssystem nach den Ansprüchen 1 bis 6 auf der Basis eines elektrischen Feldkopplungsverfahrens verwendbar ist, wobei die Vorrichtung umfasst:
ein Elektrodenpaar (120) als ein Energie übertragendes Elektrodenpaar oder ein Energie empfangendes Elektrodenpaar;
eine mit dem Elektrodenpaar verbundene Anpassungsschaltung (180), wobei die Anpassungsschaltung wenigstens eine Parallelkapazitätselementgruppe mit einer Vielzahl von wählbar ein- oder auszuschaltenden Parallelkapazitätselementen oder ein variables Parallelkapazitätselement aufweist; und
eine Steuerschaltung (112), die jeweils die Vielzahl von ein- oder auszuschaltenden Parallelkapazitätselementen oder eine Kapazität des variablen Parallelkapazitätselements steuert.

10. Vorrichtung nach Anspruch 9, die des Weiteren eine Energieumwandlungsschaltung umfasst;
wobei die Anpassungsschaltung (180) zwischen der Energieumwandlungsschaltung und dem Elektrodenpaar geschaltet ist.

11. Vorrichtung nach Anspruch 9 oder 10, wobei:
die Anpassungsschaltung (180) die Parallelkapazitätselementgruppe aufweist und
die Steuerschaltung (112) nacheinander eine Kombination der Parallelkapazitätselemente ändert, die in der ein- oder auszuschaltenden Parallelkapazitätselementgruppe enthalten sind, einen Parameter misst, der entsprechend den Übertragungseigenschaften jedes Mal variiert, wenn die Kombination geändert wird, und Messergebnisse über den Parameter vergleicht, um eine optimale Kombination der ein- oder auszuschaltenden Parallelkapazitätselemente zu bestimmen.

12. Vorrichtung nach Anspruch 9, wobei:
die Anpassungsschaltung (130) das variable Parallelkapazitätselement aufweist und
die Steuerschaltung (117) nacheinander die Kapazität des variablen Parallelkapazitätselements ändert, einen Parameter misst, der entsprechend den Übertragungseigenschaften jedes Mal variiert, wenn die Kapazität geändert wird, und Messergebnisse über den Parameter vergleicht, um einen optimalen Wert der variablen Parallelkapazität zu bestimmen.

13. Einstellverfahren mittels der Vorrichtung nach einem der Ansprüche 9 bis 12, um einen Energieübertragungstest durchzuführen, um einen optimalen Wert der Kapazität der Anpassungsschaltung in der Vorrichtung zu bestimmen.

14. Einstellverfahren nach Anspruch 13, wobei das Einstellverfahren eine Energieübertragungsvorrichtung als die Vorrichtung nach einem der Ansprüche 9 bis 12 und eine Energieempfangsvorrichtung als die Vorrichtung nach einem der Ansprüche 9 bis 12 verwendet, um einen optimalen Wert der Kapazität der Anpassungsschaltung in der Energieübertragungsvorrichtung oder der Energieempfangsvorrichtung zu bestimmen und dann einen optimalen Wert der Kapazität der Anpassungsschaltung in der anderen der Energieübertragungsvorrichtung oder der Energieempfangsvorrichtung zu bestimmen.

## Revendications

1. Système utilisable en tant qu'un d'un système de transmission d'énergie et d'un système de réception d'énergie selon un procédé de couplage de champs électriques, le système comprenant :
un premier dispositif ; et
un deuxième dispositif ;
dans lequel :
chacun du premier dispositif et du deuxième dispositif est un dispositif de transmission d'énergie dans le système de transmission d'énergie, ou chacun du premier dispositif et du deuxième dispositif est un dispositif de réception d'énergie dans le système de réception d'énergie ;
les deux des premier et deuxième dispositifs sont capables de transmettre de l'énergie à un même dispositif de réception d'énergie, ou les deux des premier et deuxième dispositifs sont capables de recevoir de l'énergie d'un même dispositif de transmission d'énergie ;
le premier dispositif inclut :
une première paire d'électrodes (120A), et
un premier circuit d'adaptation (180A) connecté à la première paire d'électrodes ;
le deuxième dispositif inclut :
une deuxième paire d'électrodes (120B), et
un deuxième circuit d'adaptation (180B) connecté à la deuxième paire d'électrodes ;
chacune de la première paire d'électrodes et de la deuxième paire d'électrodes est une paire d'électrodes de transmission d'énergie, ou chacune de la première paire d'électrodes et de la deuxième paire d'électrodes est une paire d'électrodes de réception d'énergie ;
une capacité parasite de la première paire d'électrodes est inférieure à une capacité parasite de la deuxième paire d'électrodes ; et
le premier circuit d'adaptation présente une capacité parallèle supérieure à une capacité parallèle du deuxième circuit d'adaptation, afin de fournir des caractéristiques de transmission d'énergie souhaitées.

2. Le système de la revendication 1, dans lequel :
le premier dispositif inclut en outre un premier circuit de conversion d'énergie ;
le premier circuit d'adaptation est connecté entre le premier circuit de conversion d'énergie et la première paire d'électrodes ;
le deuxième dispositif inclut en outre un deuxième circuit de conversion d'énergie ; et
le deuxième circuit d'adaptation est connecté entre le deuxième circuit de conversion d'énergie et la deuxième paire d'électrodes.

3. Le système de la revendication 1 ou 2, dans lequel le premier circuit d'adaptation inclut un circuit d'adaptation présentant la même structure que celle du deuxième circuit d'adaptation et un élément de capacité parallèle.

4. Le système de la revendication 3, dans lequel l'élément de capacité parallèle est placé à une des extrémités, du premier circuit d'adaptation, plus près de la première paire d'électrodes.

5. Le système de l'une quelconque des revendications 1 à 4, dans lequel une longueur de la première paire d'électrodes est plus courte qu'une longueur de la deuxième paire d'électrodes.

6. Le système de l'une quelconque des revendications 1 à 5, dans lequel, là où une différence entre la capacité parallèle du premier circuit d'adaptation et la capacité parallèle du deuxième circuit d'adaptation est ΔCc1 et une différence entre la capacité parasite de la deuxième paire d'électrodes et la capacité parasite de la première paire d'électrodes est ΔCsh1, une valeur absolue de (ΔCc1 - ΔCsh1)/ΔCsh1 est de 0,5 ou moins.

7. Système de transmission d'énergie sans fil, comprenant :
le système de l'une quelconque des revendications 1 à 6 ; et
un autre dispositif permettant de transmettre de l'énergie entre l'un autre dispositif et soit le premier dispositif, soit le deuxième dispositif.

8. Le premier dispositif utilisable dans le système de l'une quelconque des revendications 1 à 6.

9. Dispositif utilisable en tant que dispositif de transmission d'énergie ou dispositif de réception d'énergie pour un système de transmission d'énergie sans fil selon les revendications 1 à 6 selon un procédé de couplage de champs électriques, le dispositif comprenant :
une paire d'électrodes (120) en tant que paire d'électrodes de transmission d'énergie ou paire d'électrodes de réception d'énergie ;
un circuit d'adaptation (180) connecté à la paire d'électrodes, le circuit d'adaptation incluant au moins un d'un groupe d'éléments de capacité parallèle, incluant une pluralité d'éléments de capacité parallèle sélectionnables pour être activés ou désactivés, et un élément de capacité parallèle variable ; et
un circuit de contrôle (112) qui contrôle chacun de la pluralité d'éléments de capacité parallèle à activer ou désactiver ou contrôle une capacité de l'élément de capacité parallèle variable.

10. Le dispositif de la revendication 9, comprenant en outre un circuit de conversion d'énergie ;
dans lequel le circuit d'adaptation (180) est connecté entre le circuit de conversion d'énergie et la paire d'électrodes.

11. Le dispositif de la revendication 9 ou 10, dans lequel :
le circuit d'adaptation (180) inclut le groupe d'éléments de capacité parallèle ; et
le circuit de contrôle (112) change séquentiellement une combinaison d'éléments de capacité parallèle inclus dans le groupe d'éléments de capacité parallèle à activer ou désactiver, mesure un paramètre qui varie conformément à des caractéristiques de transmission, à chaque fois que la combinaison est changée, et compare des résultats de mesure sur le paramètre pour déterminer une combinaison optimale des éléments de capacité parallèle à activer ou désactiver.

12. Le dispositif de la revendication 9, dans lequel :
le circuit d'adaptation (130) inclut l'élément de capacité parallèle variable ; et
le circuit de contrôle (117) change séquentiellement la capacité de l'élément de capacité parallèle variable, mesure un paramètre qui varie conformément à des caractéristiques de transmission, à chaque fois que la capacité est changée, et compare des résultats de mesure sur le paramètre pour déterminer une valeur optimale de la capacité de l'élément de capacité parallèle variable.

13. Procédé d'ajustement utilisant le dispositif de l'une quelconque des revendications 9 à 12 pour procéder à un test de transmission d'énergie pour déterminer une valeur optimale de la capacité du circuit d'adaptation dans le dispositif.

14. Le procédé d'ajustement de la revendication 13, dans lequel le procédé d'ajustement utilise un dispositif de transmission d'énergie correspondant au dispositif de l'une quelconque des revendications 9 à 12 et un dispositif de réception d'énergie correspondant au dispositif de l'une quelconque des revendications 9 à 12 pour déterminer une valeur optimale de la capacité du circuit d'adaptation dans un du dispositif de transmission d'énergie et du dispositif de réception d'énergie, et puis déterminer une valeur optimale de la capacité du circuit d'adaptation dans l'autre du dispositif de transmission d'énergie et du dispositif de réception d'énergie.
